# EUROPEAN PATENT SPECIFICATION

(11) **EP 4 328 966 B1**
(45) Date of publication and mention of the grant of the patent: **01.04.2026**
(21) Application number: 23184593.4
(22) Date of filing: 11.07.2023
(51) Int. Cl.: H01L 23/522

(54) **INTEGRATED CIRCUIT STRUCTURES HAVING MAGNETIC VIAS AND BACKSIDE POWER DELIVERY**
INTEGRIERTE SCHALTUNGSSTRUKTUREN MIT MAGNETISCHEN DURCHKONTAKTIERUNGEN UND RÜCKSEITIGER STROMVERSORGUNG
STRUCTURES DE CIRCUIT INTÉGRÉ AYANT DES TROUS D'INTERCONNEXION MAGNÉTIQUES ET UNE DISTRIBUTION D'ÉNERGIE ARRIÈRE

(30) Priority: 24.08.2022 US 202217894868
(43) Date of publication of application: 28.02.2024
(73) Proprietor: INTEL Corporation, Santa Clara, CA 95054 (US)
(72) Inventor: KUTTAPPA, Ragh, Portland, 97209 (US); KARNIK, Tanay, Portland, 97229 (US); PANT, Mondira, Westborough, 01581 (US)
(74) Representative: Goddar, Heinz J.

(56) References cited:
- EP-A1- 3 869 547
- EP-A1- 4 044 231
- US-A1- 2008 001 701
- US-A1- 2018 034 369

## Description

### TECHNICAL FIELD

Embodiments of the disclosure are in the field of integrated circuit structures and processing and, in particular, integrated circuit structures having magnetic vias and backside power delivery and methods of fabricating integrated circuit structures having magnetic vias and backside power delivery.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and because they enable a less complicated tri-gate fabrication process. In another aspect, maintaining mobility improvement and short channel control as microelectronic device dimensions scale below the 10 nanometer (nm) node provides a challenge in device fabrication. Nanowires used to fabricate devices provide improved short channel control.

Scaling multi-gate and nanowire transistors has not been without consequence, however. As the dimensions of these fundamental building blocks of microelectronic circuitry are reduced and as the sheer number of fundamental building blocks fabricated in a given region is increased, the constraints on the lithographic processes used to pattern these building blocks have become overwhelming. In particular, there may be a trade-off between the smallest dimension of a feature patterned in a semiconductor stack (the critical dimension) and the spacing between such features.

In another aspect, interconnect technology enhancement are needed. US20080001701A1 describes magnetic vias used in integrated inductors and transformers to increase inductance and reduce eddy current losses, especially at high frequencies. The structure involves metal lines enclosed by magnetic materials like CoZrTa, with insulating layers to improve magnetic coupling.

EP3869547 describes gate-all-around (GAA) transistor architectures with selectively depopulated nanowire/nanoribbon channels to tune drive current. It outlines top and bottom trimming methods, self-aligned gate endcap (SAGE) structures, and asymmetric contact schemes for high-density layouts. The document covers FEOL and BEOL integration, dual epitaxial source/drain formation, and backside reveal techniques for 3D ICs.

### BRIEF DESCRIPTION OF THE DRAWINGS

Figure 1A illustrates a cross-sectional view of a metal stack, in accordance with an embodiment of the present disclosure.
Figure 1B is a schematic of a DC-DC voltage regulator, in accordance with an embodiment of the present disclosure.
Figure 1C illustrates a top view (a) and an angled cross-sectional view (b) of thick metal (e.g., TV0) vias distributed as a 2 x 5 via structure with CZT enclosure of 1µm, in accordance with an embodiment of the present disclosure.
Figure 1D is a plot of frequency versus inductance for a 2 x 5 via structure TV0 vias with CZT enclosure 1µm, in accordance with an embodiment of the present disclosure.
Figure 1E is a plot of frequency versus resistance for a 2 x 5 via structure TV0 vias with CZT enclosure 1µm, in accordance with an embodiment of the present disclosure.
Figure 1F illustrates a top view (a) and an angled cross-sectional view (b) of thick metal (e.g., TV0) vias distributed as a 4 x 10 via structure with CZT enclosure of 1µm, in accordance with an embodiment of the present disclosure.
Figure 1G is a plot 150 of frequency versus inductance for a 4 x 10 via structure TV0 vias with CZT enclosure 1µm, in accordance with an embodiment of the present disclosure.
Figure 1H is a plot 152 of frequency versus resistance for a 4 x 10 via structure TV0 vias with CZT enclosure 1µm, in accordance with an embodiment of the present disclosure.
Figure 2A is a plot of output voltage ripple waveforms showing improvements with the additional inductance of magnetic vias, in accordance with an embodiment of the present disclosure.
Figures 2B and 2C are plots of frequency versus inductance (upper plot) and frequency versus resistance (lower plot) for a 2 x 5 array TV0 vias with CZT enclosure 1µm and CZT in-between vias in accordance with an embodiment of the present disclosure.
Figure 3 illustrates cross-sectional views of an interconnect stack having front side power delivery and of an interconnect stack having backside power delivery, in accordance with an embodiment of the present disclosure.
Figure 4 illustrates a cross-sectional view of an integrated circuit structure having a nanowire layer and backside power delivery, in accordance with an embodiment of the present disclosure.
Figure 5A illustrates a plan view of a semiconductor device having a gate contact disposed over an inactive portion of a gate electrode.
Figure 5B illustrates a cross-sectional view of a non-planar semiconductor device having a gate contact disposed over an inactive portion of a gate electrode.
Figure 6A illustrates a plan view of a semiconductor device having a gate contact via disposed over an active portion of a gate electrode, in accordance with an embodiment of the present disclosure.
Figure 6B illustrates a cross-sectional view of a non-planar semiconductor device having a gate contact via disposed over an active portion of a gate electrode, in accordance with an embodiment of the present disclosure.
Figures 7A-7J illustrates cross-sectional views of various operations in a method of fabricating a gate-all-around integrated circuit structure, in accordance with an embodiment of the present disclosure.
Figure 8 illustrates a cross-sectional view of a non-planar integrated circuit structure as taken along a gate line, in accordance with an embodiment of the present disclosure.
Figure 9 illustrates cross-sectional views taken through nanowires and fins for a non-endcap architecture (left-hand side (a)) versus a self-aligned gate endcap (SAGE) architecture (right-hand side (b)), in accordance with an embodiment of the present disclosure.
Figure 10 illustrates cross-sectional views representing various operations in a method of fabricating a self-aligned gate endcap (SAGE) structure with gate-all-around devices, in accordance with an embodiment of the present disclosure.
Figure 11A illustrates a three-dimensional cross-sectional view of a nanowire-based integrated circuit structure, in accordance with an embodiment of the present disclosure.
Figure 11B illustrates a cross-sectional source or drain view of the nanowire-based integrated circuit structure of Figure 11A, as taken along the a-a' axis, in accordance with an embodiment of the present disclosure.
Figure 11C illustrates a cross-sectional channel view of the nanowire-based integrated circuit structure of Figure 11A, as taken along the b-b' axis, in accordance with an embodiment of the present disclosure.
Figure 12 illustrates a computing device in accordance with one implementation of an embodiment of the disclosure.
Figure 13 illustrates an interposer that includes one or more embodiments of the disclosure.
Figure 14A illustrates a computing device in accordance with one implementation of an embodiment of the present disclosure.
Figure 14B illustrates a processing device in accordance with one implementation of an embodiment of the present disclosure.

### DESCRIPTION OF THE EMBODIMENTS

Integrated circuit structures having magnetic vias and backside power delivery, and methods of fabricating integrated circuit structures having magnetic vias and backside power delivery, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to leveraging on-chip magnetic vias for output voltage ripple reduction in DC-DC converters. One or more embodiments described herein are directed to integrated circuit structures having a nanowire layer and backside power delivery. It is to be appreciated that, unless indicated otherwise, reference to nanowires herein can indicate nanowires or nanoribbons or even nanosheets. One or more embodiments described herein are directed to integrated circuit structures having a fin-based layer and backside power delivery.

To provide context, on-chip inductor-based DC-DC converters require bulky inductors to provide energy efficient voltage regulation with low output voltage ripple and fast transient response under varying load conditions. In addition, due to design requirements inductors cannot typically be placed close to the point of load resulting in significant losses in conversion efficiency and response time.

In accordance with one or more embodiments of the present disclosure, power delivery solutions are described to enable improvements in voltage regulation and distribution. Magnetic materials can exhibit high permeability, good linearity, and compatibility with CMOS processes. In an embodiment, a magnetic via described herein provides on-chip inductance with low area. The additional inductance from the magnetic via implemented with backside top metal layers reduces the output voltage ripple at the point of load. According to the invention the magnetic via structures uses back side top metal layers with a Cobalt Zirconium Tantalum (CZT) enclosure. Embodiments are applicable to other magnetic materials such as Nickel Iron (NiFe) and Cobalt Nickel Iron (CoNiFe). Embodiments may be directed to leveraging the magnetic via inductance in DC-DC converters.

Advantages to implementing one or more embodiments described herein can include, for on-chip power generation and distribution, implementing DC-DC converters with high power conversion efficiency over a wide load current range are necessary. Low output voltage ripple may be critical in complex designs to avoid logic failures due to variations in the voltage swing. A low voltage ripple can allow for higher design frequency. An additional inductance without the overhead of an explicit inductor can reduce the output voltage ripple at the point of load.

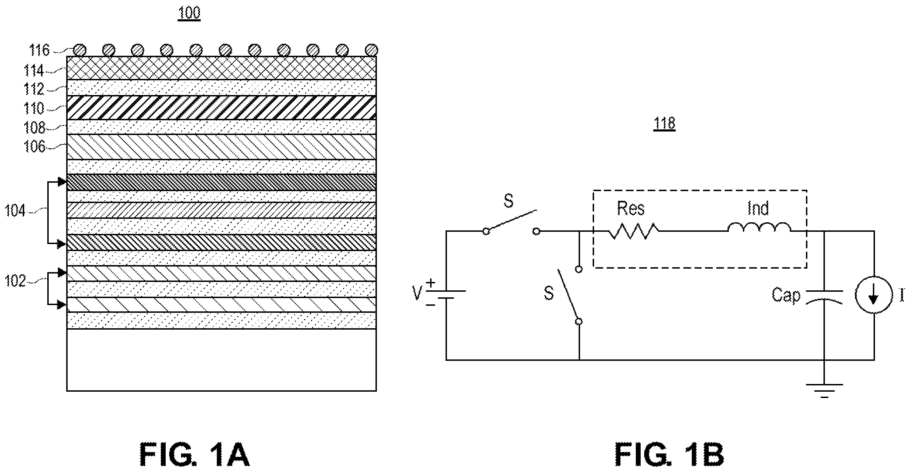

Figure 1A illustrates a cross-sectional view of a metal stack, in accordance with an embodiment of the present disclosure. Figure 1B is a schematic of a DC-DC voltage regulator, in accordance with an embodiment of the present disclosure.

Referring to Figure 1A, a metal semiconductor metal stack 100 includes lower metal layers 102, middle metal layers 104, top metal layers 106 (e.g., TM0) and 110 (e.g., TM1), top via layers 108 (e.g., TV0) and 112 (e.g., TV1), a redistribution layer 114 and interconnects 116. The metal layers can be included in and separated by a plurality of dielectric layers. The top metal layers are thick, wide, and have low resistivity which are typically used for power delivery. In an embodiment, leveraging a back side metal architecture and power delivery capabilities, magnetic via structures are implemented for on-chip voltage regulation. In an embodiment, magnetic vias are implemented with 1µm CZT enclosure to provide an additional inductance for a DC-DC converter. A DC-DC voltage regulator 118 is illustrated in Figure 1B. In an embodiment, the additional inductance from the magnetic via is shown to reduce the voltage ripple.

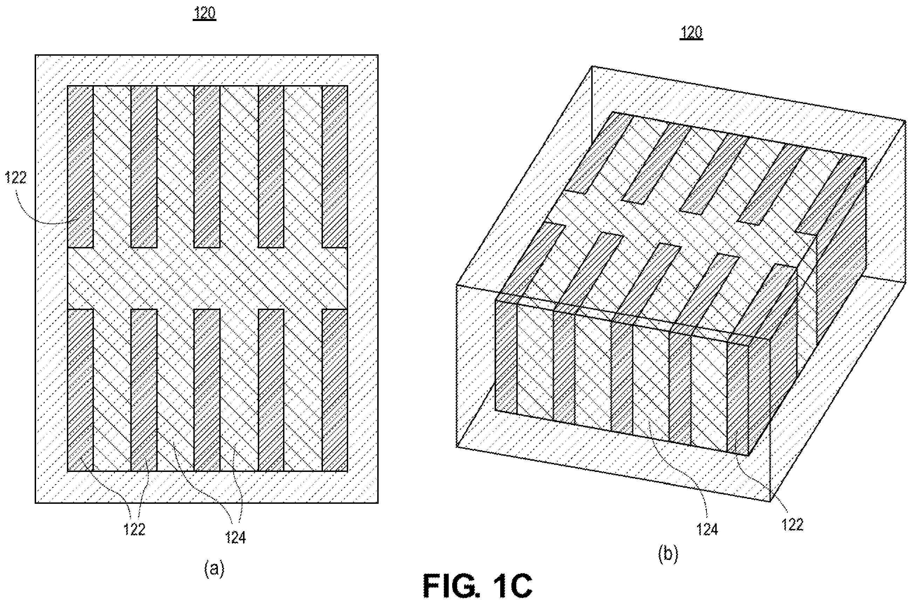

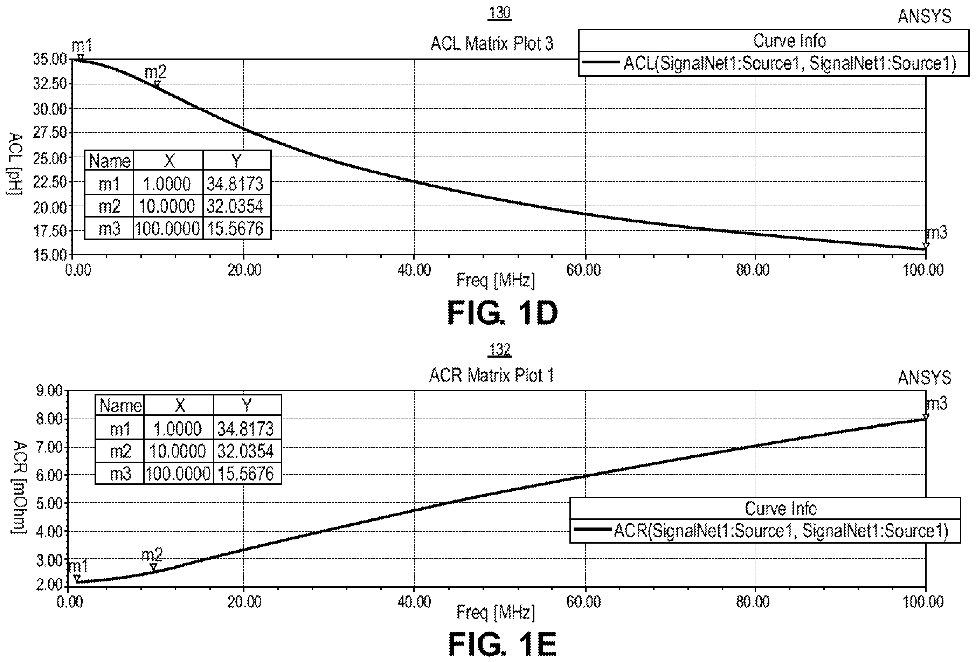

Figure 1C illustrates a top view (a) and an angled cross-sectional view (b) of thick metal (e.g., TV0) vias 122 distributed as a 2 x 5 via structure 120 with CZT enclosure 124 of 1µm, in accordance with an embodiment of the present disclosure. Figure 1D is a plot 130 of frequency versus inductance for a 2 x 5 via structure TV0 vias with CZT enclosure 1µm, in accordance with an embodiment of the present disclosure. Figure 1E is a plot 132 of frequency versus resistance for a 2 x 5 via structure TV0 vias with CZT enclosure 1µm, in accordance with an embodiment of the present disclosure.

Regarding magnetic via implementation, referring to Figure 1C, the magnetic via implementation is shown as a 2x5 via structure 120. The boundary of the 2x5 via structures is enclosed with 1µm CZT material 124. In one embodiment, the 2x5 via structure 120 of Figure 1C occupies an area of 152 µm² (10.8µm X 14µm). In Figure 1D and Figure 1E, the frequency versus inductance and frequency versus resistance plots are shown, respectively. At 1MHz, the inductance of the 2x5 via structure is ~35pH and the resistance is ~2mΩ. At 100MHz, the inductance of the 2x5 via structure is ~15pH and the resistance is ~8mΩ.

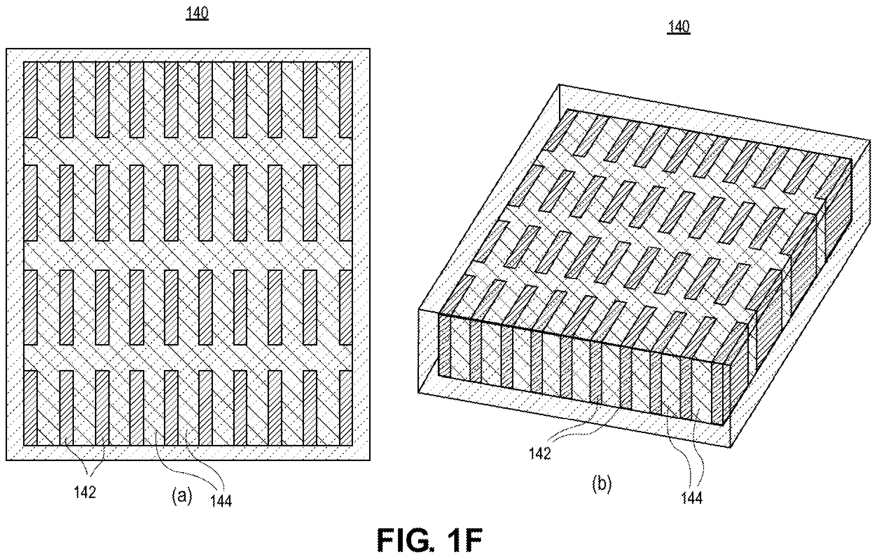

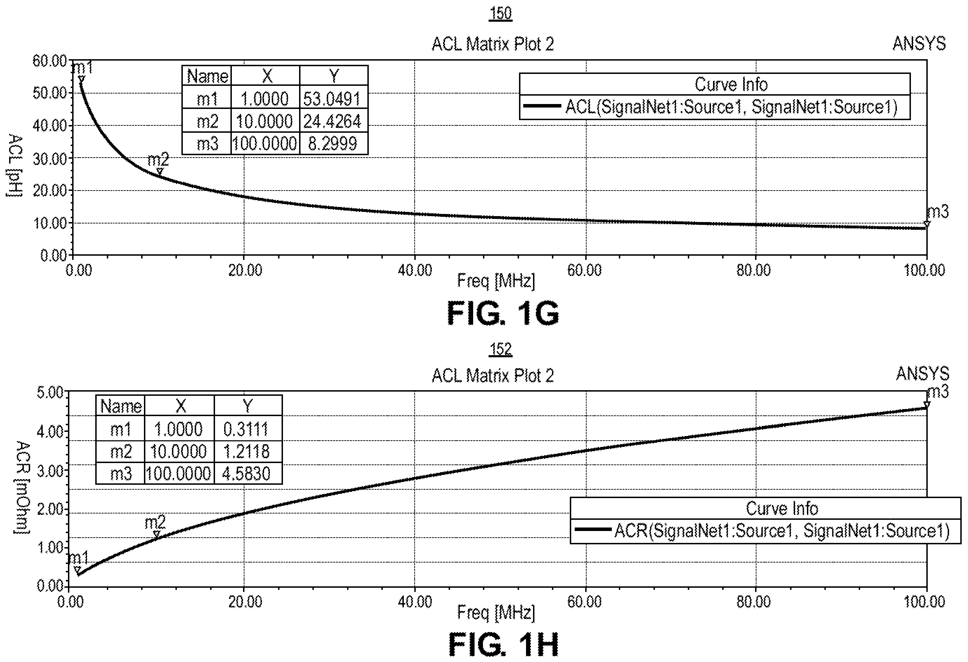

Figure 1F illustrates a top view (a) and an angled cross-sectional view (b) of thick metal (e.g., TV0) vias 142 distributed as a 4 x 10 via structure 140 with CZT enclosure 144 of 1µm, in accordance with an embodiment of the present disclosure. Figure 1G is a plot 150 of frequency versus inductance for a 4 x 10 via structure TV0 vias with CZT enclosure 1µm, in accordance with an embodiment of the present disclosure. Figure 1H is a plot 152 of frequency versus resistance for a 4 x 10 via structure TV0 vias with CZT enclosure 1µm, in accordance with an embodiment of the present disclosure.

Regarding magnetic via implementation, referring to Figure 1F, the magnetic via implementation is shown as a 4x10 via structure 140. The boundary of the 4x10 via structures is enclosed with 1µm CZT material 144. In one embodiment, the 4x10 via structure 140 of Figure 1F occupies an area of 582.4 µm² (20.8µm X 28µm). In Figure 1G and Figure 1H, the frequency versus inductance and frequency versus resistance plots are shown, respectively. At 1MHz, the inductance of the 4x10 via structure is ~53pH and the resistance is ~0.3mΩ. At 100MHz, the inductance of the 4x10 via structure is ~8pH and the resistance is ~4.5mΩ.

In another aspect, regarding DC-DC voltage regulator output voltage ripple improvement, in an embodiment, the DC-DC voltage regulator shown in Fig. 1B is implemented to demonstrate the impact of the additional inductance on the output voltage ripple. The inductance value was chosen to be 1nH and the load current is 600mA. An arbitrary value for magnetic via inductance of 50pH was chosen for the analysis.

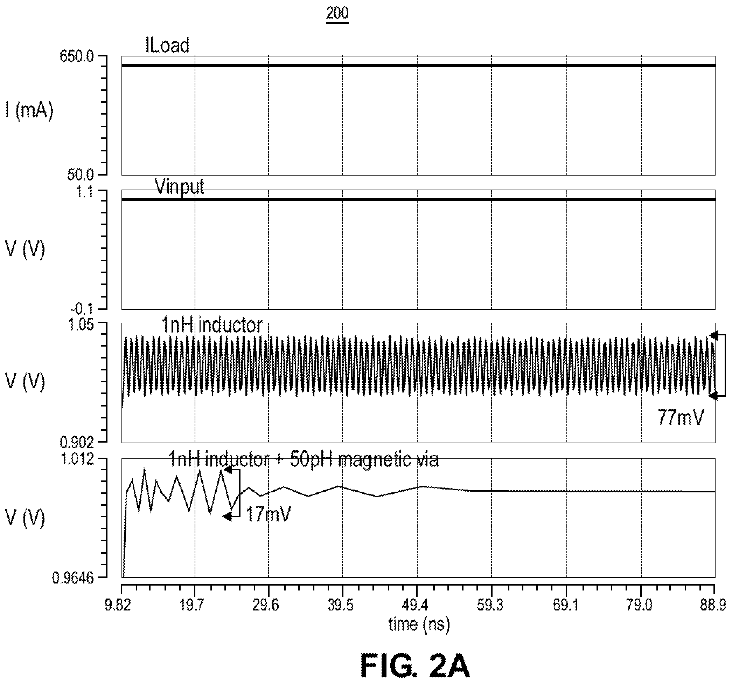

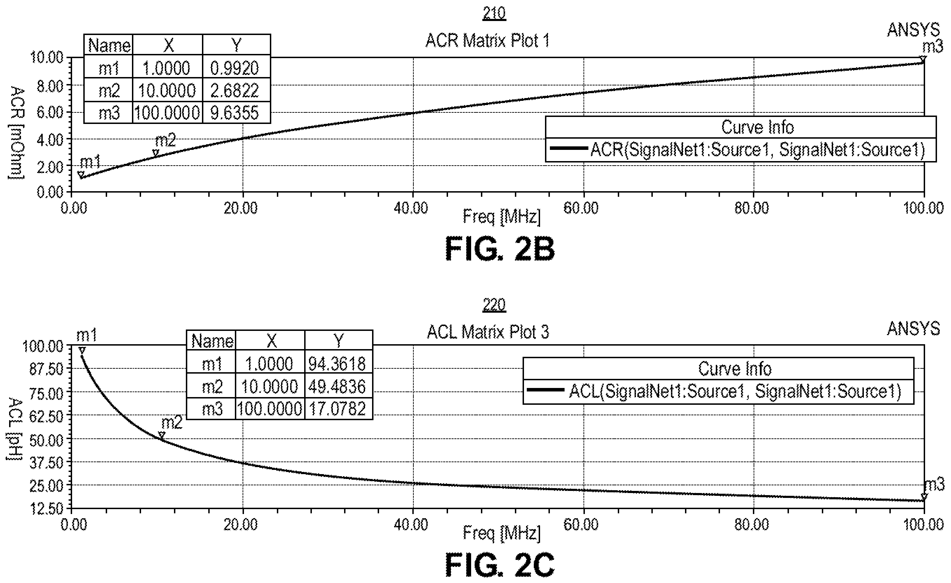

Figure 2A is a plot 200 of output voltage ripple waveforms showing improvements with the additional inductance of magnetic vias, in accordance with an embodiment of the present disclosure. Figures 2B and 2C are plots of frequency versus inductance (upper plot) and frequency versus resistance (lower plot) for a 2 x 5 array TV0 vias with CZT enclosure 1µm and CZT in-between vias in accordance with an embodiment of the present disclosure.

Referring to Figure 2A, the output voltage ripple waveforms are shown for the 2 conditions: 1) no magnetic via, and 2) 50pH magnetic via. In one embodiment, the output voltage ripple decreases by 76% with the additional inductance of the magnetic via.

Figures 2B and 2C are plots of frequency versus inductance (upper plot 210) and frequency versus resistance (lower plot 220) for a 2 x 5 array TV0 vias with CZT enclosure 1 µm and CZT in-between vias in accordance with an embodiment of the present disclosure.

Regarding a magnetic via with 1 µm CZT enclosure and CZT in-between vias, in an embodiment, implementing a 2x5 via structure with a 1µm CZT enclosure and CZT in-between the vias shows an increase in inductance and decrease in resistance as shown in Figures 2B and 2C. In one embodiment, the inductance increases from 34.9pH@1MHz to 94.36pH@1MHz (170% increase) and resistance decreases from 2.12mΩ@1MHz to 0.99mΩ@1MHz (53% decrease). In one embodiment, the self-inductance loop created between the vias increases the inductance and decreases resistance due to the magnetic properties of the CZT material. Furthermore, in an embodiment, the total inductance can be enhanced by implementing magnetic material surrounding the power routing.

Embodiments can be implemented herein to provide a magnetic via that can be manufactured using existing semiconductor processing methods with magnetic materials. The simulation-based results described herein show the inductance and resistance properties of the magnetic via structures. In one embodiment, a DC-DC converter simulated with an additional 50 pH inductance of the magnetic via results in 76% reduction in the output voltage ripple.

To provide further context, in standard cell design, the diffusion placement and metal routing layers are designed around a power delivery scheme. It can be through front side bump to the M0 and the diffusion contact or in the newer architectures it can be through wafer backside metals would be tapped through a via that would contact the diffusion contact on the front side. When these are performed, either on the front side metals or the diffusion there is a space allocation for the delivery of power.

Traditionally, power is delivered from a front side interconnect. At standard cell level, power can be delivered right on top of transistors or from a top and bottom cell boundary. Power delivered from a top and bottom cell boundary enables relatively shorter standard cell height with slightly higher power network resistance. However, a front side power network shares interconnect stack with signal routing and reduces signal routing tracks. In addition, for high performance design, top and bottom cell boundary power metal wires must be wide enough to reduce power network resistance and improve performance. This normally results in a cell height increase. In accordance with one or more embodiments of the present disclosure, delivering power from a wafer or substrate backside can be implemented to solve area and performance problems. At the cell level, wider metal 0 power at the top and bottom cell boundary may no longer be needed and, hence, cell height can be reduced. In addition, power network resistance can be significantly reduced resulting in performance improvement. At block and chip level, front side signal routing tracks are increased due to removed power routing and power network resistance is significantly reduced due to very wide wires, large vias and reduced interconnect layers.

In earlier technologies, a power delivery network from bump to the transistor required significant block resources. Such resource usage on the metal stack expressed itself in some process nodes as Standard Cell architectures with layout versioning or cell placement restrictions in the block level. In an embodiment, eliminating the power delivery network from the front side metal stack allows free sliding cell placement in the block without power delivery complications and placement related delay timing variation.

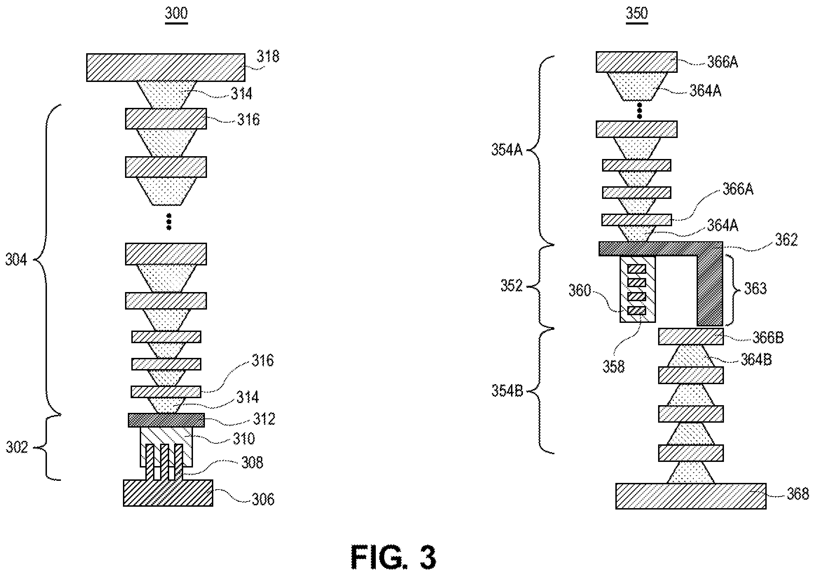

As a comparison, Figure 3 illustrates cross-sectional views of an interconnect stack having front side power delivery and of an interconnect stack having backside power delivery, in accordance with an embodiment of the present disclosure.

Referring to Figure 3, an interconnect stack 300 having front side power delivery includes a transistor 302 and signal and power delivery metallization 304. The transistor 302 includes a bulk substrate 306, semiconductor fins 308, a terminal 310, and a device contact 312. The signal and power delivery metallization 304 includes conductive vias 314, conductive lines 316, and a metal bump 318.

Referring again to Figure 3, an interconnect stack 350 having backside power delivery includes a transistor 352, front side signal metallization 354A, and power delivery metallization 354B. The transistor 352 includes semiconductor nanowires or nanoribbons 358, a terminal 360, and a device contact 362, and a boundary deep via 363. The front side signal metallization 354A includes conductive vias 364A and conductive lines 366A. The power delivery metallization 354B includes conductive vias 364B, conductive lines 366B, and a metal bump 368.

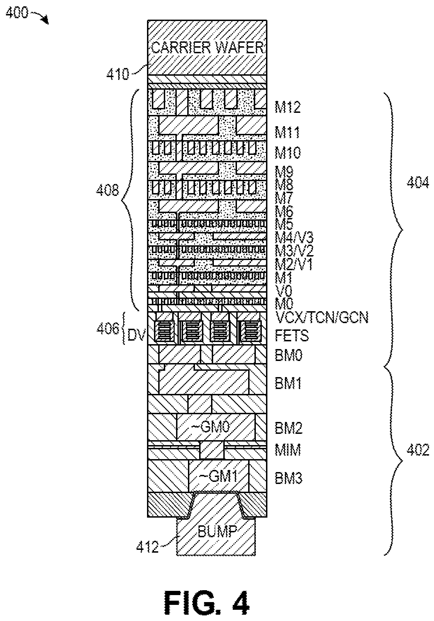

As an exemplary structure including signal lines as front-end lines and power structures in a backside, Figure 4 illustrates a cross-sectional view of an integrated circuit structure having a nanowire layer and backside power delivery, in accordance with an embodiment of the present disclosure. It is to be appreciated that although nanowires (or nanoribbons or nanosheets) are depicted in Figure 4, a fin-based architecture can also be used.

Referring to Figure 4, an integrated circuit structure 400 includes a front-side structure 404 on a backside structure 402. The front-side structure 404 includes a device layer 406, and a plurality of metallization layers 408 on the device layer 406. The structure 400 may be supported by a carrier wafer 410 on the front-side structure 404. The backside structure 402 includes a stack of backside conductive structures that terminate at a conductive bump 412.

In an embodiment, the device layer 406 includes Field Effect Transistors (FETs), such as nanowire-based (shown) or fin-based transistors. In one such, embodiment, the FETs are used for logic and/or for memory. In an embodiment, the device layer 406 further includes trench contacts (TCN), gate contacts (GCN) and contact vias (VCX). In an embodiment, the device layer 406 is on a deep via (DV) layer of the front-side structure 404, as is depicted. In an embodiment, the plurality of metallization layers 408 includes increasing metal layer (e.g., M0-M12) and associated via layers (e.g., V0-V3 called out in Figure 4). In an embodiment, one of the via layers includes one or more magnetic vias, examples of which is described in association with Figures 1A-1H and 2A-2C.

In an embodiment, the backside structure 402 includes a plurality of backside metal layers (e.g., BM0-BM3) and associated vias. In an embodiment, the backside structure 402 includes one or more power structures, such as ground metal lines (e.g., GM0 and GM1). In an embodiment, the backside structure 402 includes one or more capacitor structures, such as a metal-insulator-metal (MIM) capacitor. In an embodiment, one of the via layers includes one or more magnetic vias, examples of which is described in association with Figures 1A-1H and 2A-2C.

In another aspect, contact over active gate (COAG) structures and processes are described, e.g., a structure that may further enable compaction of a cell architecture that includes backside power staples. One or more embodiments of the present disclosure are directed to semiconductor structures or devices having one or more gate contact structures (e.g., as gate contact vias) disposed over active portions of gate electrodes of the semiconductor structures or devices. One or more embodiments of the present disclosure are directed to methods of fabricating semiconductor structures or devices having one or more gate contact structures formed over active portions of gate electrodes of the semiconductor structures or devices. Approaches described herein may be used to reduce a standard cell area by enabling gate contact formation over active gate regions. In accordance with one or more embodiments, tapered gate and trench contacts are implemented to enable COAG fabrication. Embodiments may be implemented to enable patterning at tight pitches.

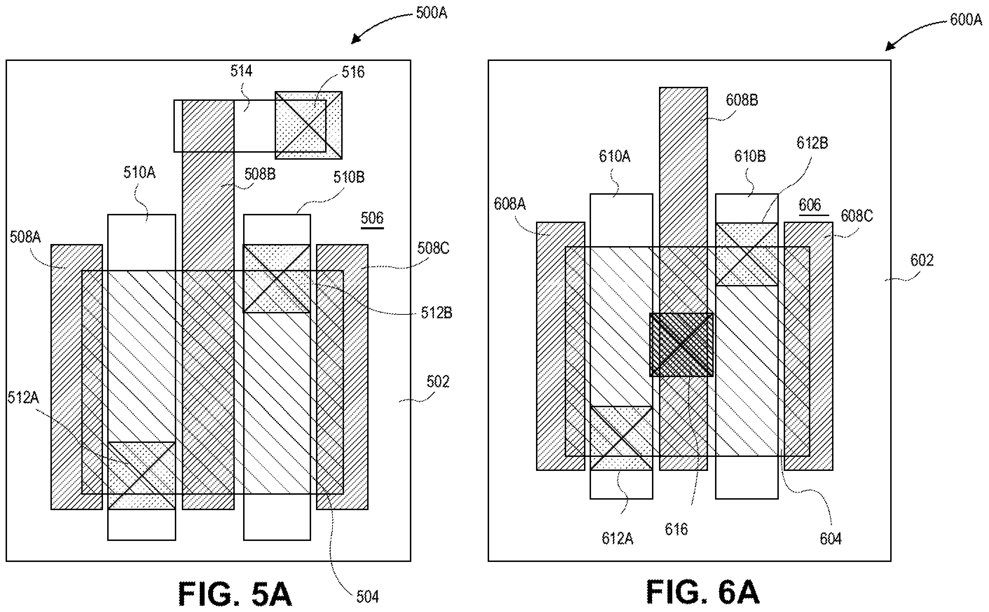

To provide further background for the importance of a COAG processing scheme, in technologies where space and layout constraints are somewhat relaxed compared with current generation space and layout constraints, a contact to gate structure may be fabricated by making contact to a portion of the gate electrode disposed over an isolation region. As an example, Figure 5A illustrates a plan view of a semiconductor device having a gate contact disposed over an inactive portion of a gate electrode.

Referring to Figure 5A, a semiconductor structure or device 500A includes a diffusion or active region 504 disposed in a substrate 502, and within an isolation region 506. One or more gate lines (also known as poly lines), such as gate lines 508A, 508B and 508C are disposed over the diffusion or active region 504 as well as over a portion of the isolation region 506. Source or drain contacts (also known as trench contacts), such as contacts 510A and 510B, are disposed over source and drain regions of the semiconductor structure or device 500A. Trench contact vias 512A and 512B provide contact to trench contacts 510A and 510B, respectively. A separate gate contact 514, and overlying gate contact via 516, provides contact to gate line 508B. In contrast to the source or drain trench contacts 510A or 510B, the gate contact 514 is disposed, from a plan view perspective, over isolation region 506, but not over diffusion or active region 504. Furthermore, neither the gate contact 514 nor gate contact via 516 is disposed between the source or drain trench contacts 510A and 510B.

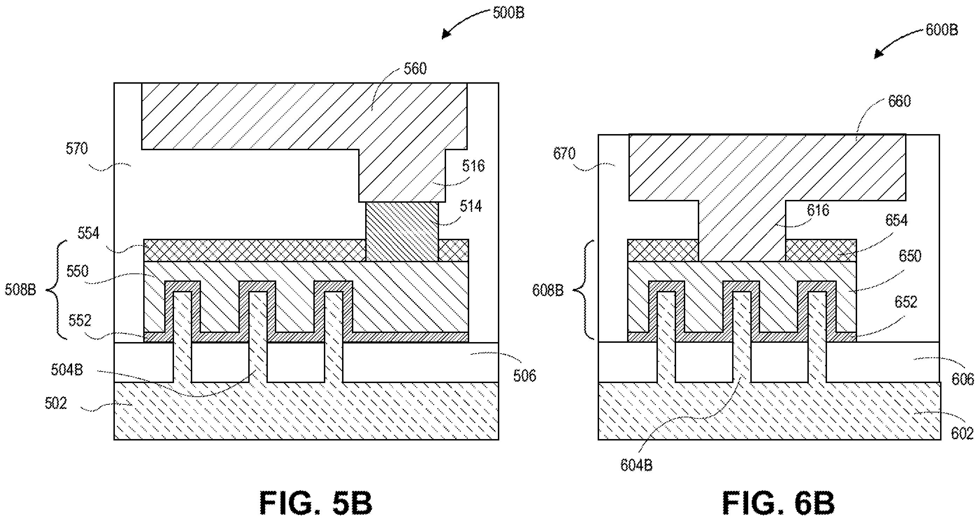

Figure 5B illustrates a cross-sectional view of a non-planar semiconductor device having a gate contact disposed over an inactive portion of a gate electrode. Referring to Figure 5B, a semiconductor structure or device 500B, e.g. a non-planar version of device 500A of Figure 5A, includes a non-planar diffusion or active region 504B (e.g., a fin structure) formed from substrate 502, and within isolation region 506. Gate line 508B is disposed over the non-planar diffusion or active region 504B as well as over a portion of the isolation region 506. As shown, gate line 508B includes a gate electrode 550 and gate dielectric layer 552, along with a dielectric cap layer 554. Gate contact 514, and overlying gate contact via 516 are also seen from this perspective, along with an overlying metal interconnect 560, all of which are disposed in inter-layer dielectric stacks or layers 570. Also seen from the perspective of Figure 5B, the gate contact 514 is disposed over isolation region 506, but not over non-planar diffusion or active region 504B.

Referring again to Figures 5A and 5B, the arrangement of semiconductor structure or device 500A and 500B, respectively, places the gate contact over isolation regions. Such an arrangement wastes layout space. However, placing the gate contact over active regions would require either an extremely tight registration budget or gate dimensions would have to increase to provide enough space to land the gate contact. Furthermore, historically, contact to gate over diffusion regions has been avoided for risk of drilling through other gate material (e.g., polysilicon) and contacting the underlying active region. One or more embodiments described herein address the above issues by providing feasible approaches, and the resulting structures, to fabricating contact structures that contact portions of a gate electrode formed over a diffusion or active region.

As an example, Figure 6A illustrates a plan view of a semiconductor device having a gate contact via disposed over an active portion of a gate electrode, in accordance with an embodiment of the present disclosure. Referring to Figure 6A, a semiconductor structure or device 600A includes a diffusion or active region 604 disposed in a substrate 602, and within an isolation region 606. One or more gate lines, such as gate lines 608A, 608B and 608C are disposed over the diffusion or active region 604 as well as over a portion of the isolation region 606. Source or drain trench contacts, such as trench contacts 610A and 610B, are disposed over source and drain regions of the semiconductor structure or device 600A. Trench contact vias 612A and 612B provide contact to trench contacts 610A and 610B, respectively. A gate contact via 616, with no intervening separate gate contact layer, provides contact to gate line 608B. In contrast to Figure 5A, the gate contact 616 is disposed, from a plan view perspective, over the diffusion or active region 604 and between the source or drain contacts 610A and 610B.

Figure 6B illustrates a cross-sectional view of a non-planar semiconductor device having a gate contact via disposed over an active portion of a gate electrode, in accordance with an embodiment of the present disclosure. Referring to Figure 6B, a semiconductor structure or device 600B, e.g. a non-planar version of device 600A of Figure 6A, includes a non-planar diffusion or active region 604B (e.g., a fin structure) formed from substrate 602, and within isolation region 606. Gate line 608B is disposed over the non-planar diffusion or active region 604B as well as over a portion of the isolation region 606. As shown, gate line 608B includes a gate electrode 650 and gate dielectric layer 652, along with a dielectric cap layer 654. The gate contact via 616 is also seen from this perspective, along with an overlying metal interconnect 660, both of which are disposed in inter-layer dielectric stacks or layers 670. Also seen from the perspective of Figure 6B, the gate contact via 616 is disposed over non-planar diffusion or active region 604B.

Thus, referring again to Figures 6A and 6B, in an embodiment, trench contact vias 612A, 612B and gate contact via 616 are formed in a same layer and are essentially co-planar. In comparison to Figures 5A and 5B, the contact to the gate line would otherwise include and additional gate contact layer, e.g., which could be run perpendicular to the corresponding gate line. In the structure(s) described in association with Figures 6A and 6B, however, the fabrication of structures 600A and 600B, respectively, enables the landing of a contact directly from a metal interconnect layer on an active gate portion without shorting to adjacent source drain regions. In an embodiment, such an arrangement provides a large area reduction in circuit layout by eliminating the need to extend transistor gates on isolation to form a reliable contact. As used throughout, in an embodiment, reference to an active portion of a gate refers to that portion of a gate line or structure disposed over (from a plan view perspective) an active or diffusion region of an underlying substrate. In an embodiment, reference to an inactive portion of a gate refers to that portion of a gate line or structure disposed over (from a plan view perspective) an isolation region of an underlying substrate.

In an embodiment, the semiconductor structure or device 600 is a non-planar device such as, but not limited to, a fin-FET or a tri-gate device. In such an embodiment, a corresponding semiconducting channel region is composed of or is formed in a three-dimensional body. In one such embodiment, the gate electrode stacks of gate lines 608A and 608B surround at least a top surface and a pair of sidewalls of the three-dimensional body. In another embodiment, at least the channel region is made to be a discrete three-dimensional body, such as in a gate-all-around device. In one such embodiment, the gate electrode stacks of gate lines 608A and 608B each completely surrounds the channel region.

Generally, one or more embodiments are directed to approaches for, and structures formed from, landing a gate contact via directly on an active transistor gate. Such approaches may eliminate the need for extension of a gate line on isolation for contact purposes. Such approaches may also eliminate the need for a separate gate contact (GCN) layer to conduct signals from a gate line or structure. In an embodiment, eliminating the above features is achieved by recessing contact metals in a trench contact (TCN) and introducing an additional dielectric material in the process flow (e.g., trench insulating layer (TILA)). The additional dielectric material is included as a trench contact dielectric cap layer with etch characteristics different from the gate dielectric material cap layer used for trench contact alignment in a gate aligned contact process (GAP) processing scheme (e.g., use of a gate insulating layer (GILA)).

As an exemplary fabrication scheme, a starting structure includes one or more gate stack structures disposed above a substrate. The gate stack structures may include a gate dielectric layer and a gate electrode. Trench contacts, e.g., contacts to diffusion regions of the substrate or to epitaxial region formed within the substrate are spaced apart from gate stack structures by dielectric spacers. An insulating cap layer may be disposed on the gate stack structures (e.g., GILA). In one embodiment, contact blocking regions or "contact plugs", which may be fabricated from an inter-layer dielectric material, are included in regions where contact formation is to be blocked.

In an embodiment, the contact pattern is essentially perfectly aligned to an existing gate pattern while eliminating the use of a lithographic operation with exceedingly tight registration budget. In one such embodiment, this approach enables the use of intrinsically highly selective wet etching (or anisotropic dry etch processes some of which are non-plasma, gas phase isotropic etches (e.g., versus classic dry or plasma etching)) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in other approaches. This also allows for perfect or near-perfect self-alignment with a larger edge placement error margin. In an embodiment, a trench contact grid is not separately patterned, but is rather formed between poly (gate) lines. For example, in one such embodiment, a trench contact grid is formed subsequent to gate grating patterning but prior to gate grating cuts.

Furthermore, the gate stack structures may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including SF₆. In another embodiment, dummy gates are composed of polycrystalline silicon or amorphous silicon and are removed with a wet etch process including aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed, is performed at a temperature greater than approximately 600 degrees Celsius. The anneal is performed prior to formation of the permanent contacts.

Next, the trench contacts may be recessed to provide recessed trench contacts that have a height below the top surface of adjacent spacers. An insulating cap layer is then formed on the recessed trench contacts (e.g., TILA). In accordance with an embodiment of the present disclosure, the insulating cap layer on the recessed trench contacts is composed of a material having a different etch characteristic than insulating cap layer on the gate stack structures.

The trench contacts may be recessed by a process selective to the materials of the spacers and the gate insulating cap layer. For example, in one embodiment, the trench contacts are recessed by an etch process such as a wet etch process or dry etch process. The trench contact insulating cap layer may be formed by a process suitable to provide a conformal and sealing layer above the exposed portions of the trench contacts. For example, in one embodiment, the trench contact insulating cap layer is formed by a chemical vapor deposition (CVD) process as a conformal layer above the entire structure. The conformal layer is then planarized, e.g., by chemical mechanical polishing (CMP), to provide the trench contact insulating cap layer material only above the recessed trench contacts.

Regarding suitable material combinations for gate or trench contact insulating cap layers, in one embodiment, one of the pair of gate versus trench contact insulating cap material is composed of silicon oxide while the other is composed of silicon nitride. In another embodiment, one of the pair of gate versus trench contact insulating cap material is composed of silicon oxide while the other is composed of carbon doped silicon nitride. In another embodiment, one of the pair of gate versus trench contact insulating cap material is composed of silicon oxide while the other is composed of silicon carbide. In another embodiment, one of the pair of gate versus trench contact insulating cap material is composed of silicon nitride while the other is composed of carbon doped silicon nitride. In another embodiment, one of the pair of gate versus trench contact insulating cap material is composed of silicon nitride while the other is composed of silicon carbide. In another embodiment, one of the pair of gate versus trench contact insulating cap material is composed of carbon doped silicon nitride while the other is composed of silicon carbide.

In another aspect, nanowire or nanoribbon structures are described. Nanowire or nanoribbon release processing may be performed through a replacement gate trench. Examples of such release processes are described below. Additionally, in yet another aspect, backend (BE) interconnect scaling can result in lower performance and higher manufacturing cost due to patterning complexity. Embodiments described herein may be implemented to enable front-side and back-side interconnect integration for nanowire transistors. Embodiments described herein may provide an approach to achieve a relatively wider interconnect pitch. The result may be improved product performance and lower patterning costs. Embodiments may be implemented to enable robust functionality of scaled nanowire or nanoribbon transistors with low power and high performance.

In another aspect, it is to be appreciated that the embodiments described herein can also include other implementations such as nanowires and/or nanoribbons with various widths, thicknesses and/or materials including but not limited to Si and SiGe. For example, group III-V materials may be used.

It is to be appreciated that, in a particular embodiment, nanowires or nanoribbons, or sacrificial intervening layers, may be composed of silicon. As used throughout, a silicon layer may be used to describe a silicon material composed of a very substantial amount of, if not all, silicon. However, it is to be appreciated that, practically, 100% pure Si may be difficult to form and, hence, could include a tiny percentage of carbon, germanium or tin. Such impurities may be included as an unavoidable impurity or component during deposition of Si or may "contaminate" the Si upon diffusion during post deposition processing. As such, embodiments described herein directed to a silicon layer may include a silicon layer that contains a relatively small amount, e.g., "impurity" level, non-Si atoms or species, such as Ge, C or Sn. It is to be appreciated that a silicon layer as described herein may be undoped or may be doped with dopant atoms such as boron, phosphorous or arsenic.

It is to be appreciated that, in a particular embodiment, nanowires or nanoribbons, or sacrificial intervening layers, may be composed of silicon germanium. As used throughout, a silicon germanium layer may be used to describe a silicon germanium material composed of substantial portions of both silicon and germanium, such as at least 5% of both. In some embodiments, the amount of germanium is greater than the amount of silicon. In particular embodiments, a silicon germanium layer includes approximately 60% germanium and approximately 40% silicon (Si₄₀Ge₆₀). In other embodiments, the amount of silicon is greater than the amount of germanium. In particular embodiments, a silicon germanium layer includes approximately 30% germanium and approximately 70% silicon (Si₇₀Ge₃₀). It is to be appreciated that, practically, 100% pure silicon germanium (referred to generally as SiGe) may be difficult to form and, hence, could include a tiny percentage of carbon or tin. Such impurities may be included as an unavoidable impurity or component during deposition of SiGe or may "contaminate" the SiGe upon diffusion during post deposition processing. As such, embodiments described herein directed to a silicon germanium layer may include a silicon germanium layer that contains a relatively small amount, e.g., "impurity" level, non-Ge and non-Si atoms or species, such as carbon or tin. It is to be appreciated that a silicon germanium layer as described herein may be undoped or may be doped with dopant atoms such as boron, phosphorous or arsenic.

Described below are various devices and processing schemes that may be used to fabricate a device that can be integrated with a structure having magnetic vias and backside power delivery. It is to be appreciated that the exemplary embodiments need not necessarily require all features described, or may include more features than are described. For example, nanowire release processing may be performed through a replacement gate trench. Examples of such release processes are described below. Additionally, in yet another aspect, backend (BE) interconnect scaling can result in lower performance and higher manufacturing cost due to patterning complexity. Embodiments described herein may be implemented to enable front-side and back-side interconnect integration for nanowire transistors. Embodiments described herein may provide an approach to achieve a relatively wider interconnect pitch. The result may be improved product performance and lower patterning costs. Embodiments may be implemented to enable robust functionality of scaled nanowire or nanoribbon transistors with low power and high performance.

One or more embodiments described herein are directed dual epitaxial (EPI) connections for nanowire or nanoribbon transistors using partial source or drain (SD) and asymmetric trench contact (TCN) depth. In an embodiment, an integrated circuit structure is fabricated by forming source-drain openings of nanowire/nanoribbon transistors which are partially filled with SD epitaxy. A remainder of the opening is filled with a conductive material. Deep trench formation on one of the source or drain side enables direct contact to a back-side interconnect level.

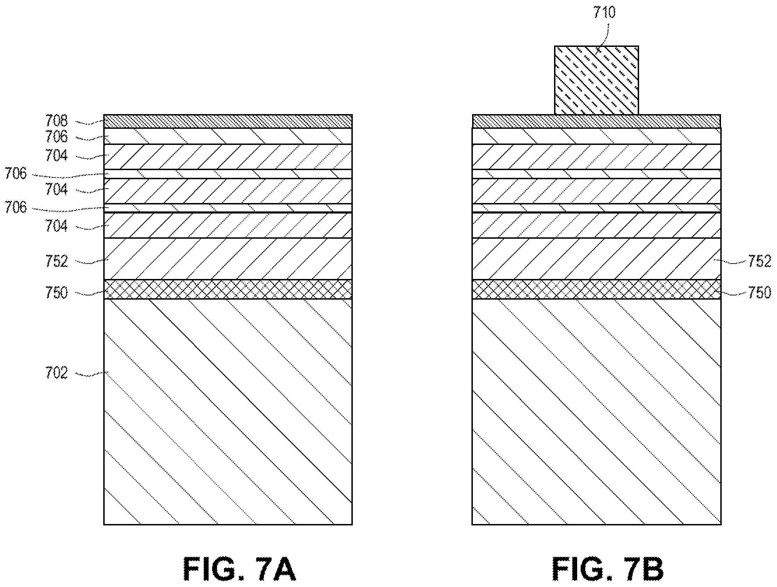

As an exemplary process flow for fabricating a gate-all-around device of a gate-all-around integrated circuit structure, Figures 7A-7J illustrates cross-sectional views of various operations in a method of fabricating a gate-all-around integrated circuit structure, in accordance with an embodiment of the present disclosure.

Referring to Figure 7A, a method of fabricating an integrated circuit structure includes forming a starting stack which includes alternating sacrificial layers 704 and nanowires 706 above a fin 702, such as a silicon fin. The nanowires 706 may be referred to as a vertical arrangement of nanowires. A protective cap 708 may be formed above the alternating sacrificial layers 704 and nanowires 706, as is depicted. A relaxed buffer layer 752 and a defect modification layer 750 may be formed beneath the alternating sacrificial layers 704 and nanowires 706, as is also depicted.

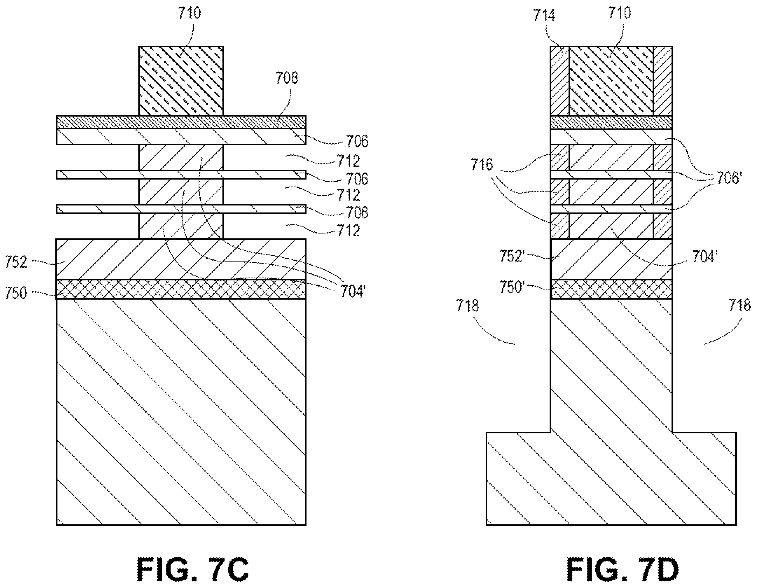

Referring to Figure 7B, a gate stack 710 is formed over the vertical arrangement of horizontal nanowires 706. Portions of the vertical arrangement of horizontal nanowires 706 are then released by removing portions of the sacrificial layers 704 to provide recessed sacrificial layers 704' and cavities 712, as is depicted in Figure 7C.

It is to be appreciated that the structure of Figure 7C may be fabricated to completion without first performing the deep etch and asymmetric contact processing described below. In either case (e.g., with or without asymmetric contact processing), in an embodiment, a fabrication process involves use of a process scheme that provides a gate-all-around integrated circuit structure having epitaxial nubs, which may be vertically discrete source or drain structures.

Referring to Figure 7D, upper gate spacers 714 are formed at sidewalls of the gate structure 710. Cavity spacers 716 are formed in the cavities 712 beneath the upper gate spacers 714. A deep trench contact etch is then optionally performed to form trenches 718 and to form recessed nanowires 706'. A patterned relaxed buffer layer 752' and a patterned defect modification layer 750' may also be present, as is depicted.

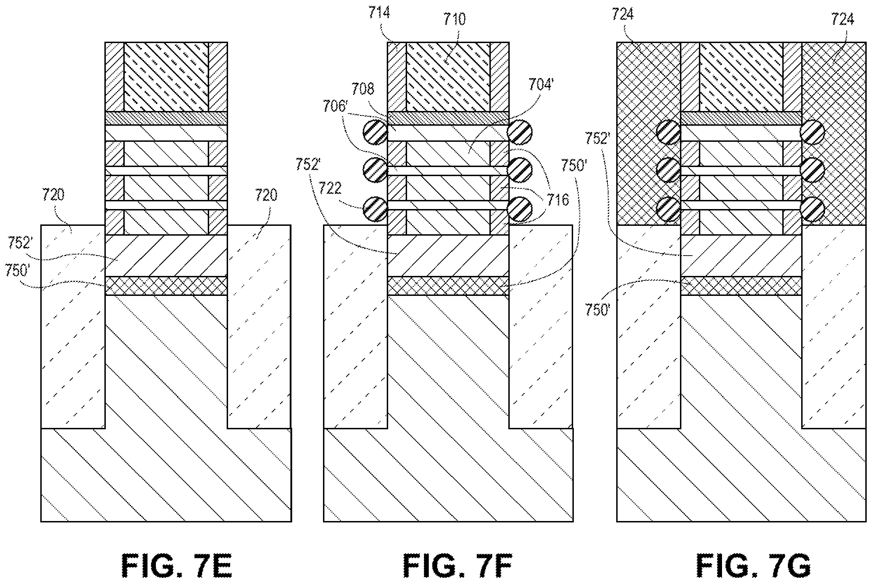

A sacrificial material 720 is then formed in the trenches 718, as is depicted in Figure 7E. In other process schemes, an isolated trench bottom or silicon trench bottom may be used.

Referring to Figure 7F, a first epitaxial source or drain structure (e.g., left-hand features 722) is formed at a first end of the vertical arrangement of horizontal nanowires 706'. A second epitaxial source or drain structure (e.g., right-hand features 722) is formed at a second end of the vertical arrangement of horizontal nanowires 706'. In an embodiment, as depicted, the epitaxial source or drain structures 722 are vertically discrete source or drain structures and may be referred to as epitaxial nubs.

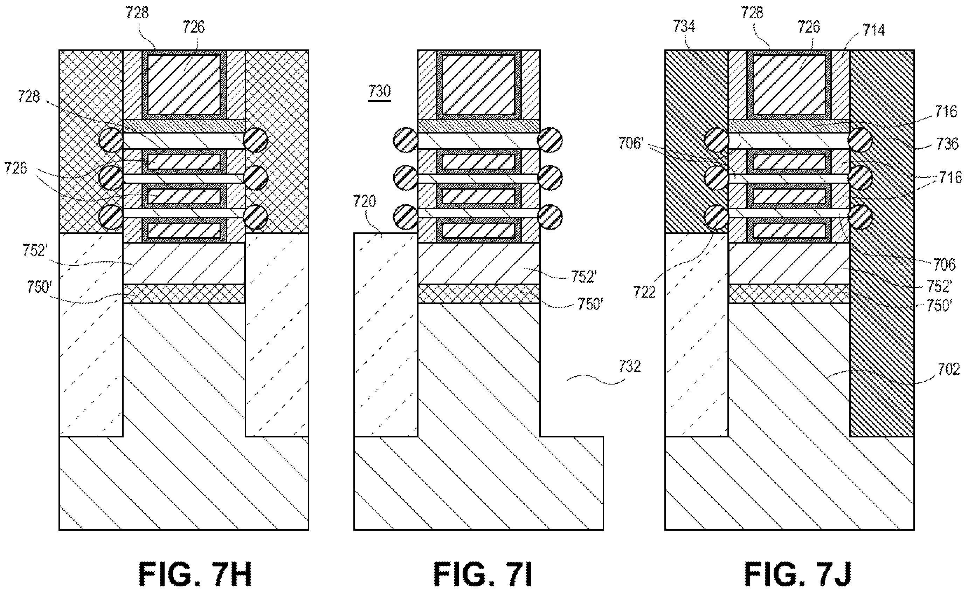

An inter-layer dielectric (ILD) material 724 is then formed at the sides of the gate electrode 710 and adjacent the source or drain structures 722, as is depicted in Figure 7G. Referring to Figure 7H, a replacement gate process is used to form a permanent gate dielectric 728 and a permanent gate electrode 726. The ILD material 724 is then removed, as is depicted in Figure 7I. The sacrificial material 720 is then removed from one of the source drain locations (e.g., right-hand side) to form trench 732, but is not removed from the other of the source drain locations to form trench 730.

Referring to Figure 7J, a first conductive contact structure 734 is formed coupled to the first epitaxial source or drain structure (e.g., left-hand features 722). A second conductive contact structure 736 is formed coupled to the second epitaxial source or drain structure (e.g., right-hand features 722). The second conductive contact structure 736 is formed deeper along the fin 702 than the first conductive contact structure 734. In an embodiment, although not depicted in Figure 7J, the method further includes forming an exposed surface of the second conductive contact structure 736 at a bottom of the fin 702. Conductive contacts may include a contact resistance reducing layer and a primary contact electrode layer, where examples can include Ti, Ni, Co (for the former and W, Ru, Co for the latter.)

In an embodiment, the second conductive contact structure 736 is deeper along the fin 702 than the first conductive contact structure 734, as is depicted. In one such embodiment, the first conductive contact structure 734 is not along the fin 702, as is depicted. In another such embodiment, not depicted, the first conductive contact structure 734 is partially along the fin 702.

In an embodiment, the second conductive contact structure 736 is along an entirety of the fin 702. In an embodiment, although not depicted, in the case that the bottom of the fin 702 is exposed by a back-side substrate removal process, the second conductive contact structure 736 has an exposed surface at a bottom of the fin 702.

In an embodiment, the structure of Figure 7J, or related structures of Figures 7A-7J, can be included in a structure including magnetic vias and backside power delivery, such as described above.

In another aspect, in order to enable access to both conductive contact structures of a pair of asymmetric source and drain contact structures, integrated circuit structures described herein may be fabricated using a back-side reveal of front-side structures fabrication approach. In some exemplary embodiments, reveal of the back-side of a transistor or other device structure entails wafer-level back-side processing. In contrast to a conventional TSV-type technology, a reveal of the back-side of a transistor as described herein may be performed at the density of the device cells, and even within sub-regions of a device. Furthermore, such a reveal of the back-side of a transistor may be performed to remove substantially all of a donor substrate upon which a device layer was disposed during front-side device processing. As such, a microns-deep TSV becomes unnecessary with the thickness of semiconductor in the device cells following a reveal of the back-side of a transistor potentially being only tens or hundreds of nanometers.

Reveal techniques described herein may enable a paradigm shift from "bottom-up" device fabrication to "center-out" fabrication, where the "center" is any layer that is employed in front-side fabrication, revealed from the back-side, and again employed in back-side fabrication. Processing of both a front-side and revealed back-side of a device structure may address many of the challenges associated with fabricating 3D ICs when primarily relying on front-side processing.

A reveal of the back-side of a transistor approach may be employed for example to remove at least a portion of a carrier layer and intervening layer of a donor-host substrate assembly. The process flow begins with an input of a donor-host substrate assembly. A thickness of a carrier layer in the donor-host substrate is polished (e.g., CMP) and/or etched with a wet or dry (e.g., plasma) etch process. Any grind, polish, and/or wet/dry etch process known to be suitable for the composition of the carrier layer may be employed. For example, where the carrier layer is a group IV semiconductor (e.g., silicon) a CMP slurry known to be suitable for thinning the semiconductor may be employed. Likewise, any wet etchant or plasma etch process known to be suitable for thinning the group IV semiconductor may also be employed.

In some embodiments, the above is preceded by cleaving the carrier layer along a fracture plane substantially parallel to the intervening layer. The cleaving or fracture process may be utilized to remove a substantial portion of the carrier layer as a bulk mass, reducing the polish or etch time needed to remove the carrier layer. For example, where a carrier layer is 400-900 µm in thickness, 100-700 µm may be cleaved off by practicing any blanket implant known to promote a wafer-level fracture. In some exemplary embodiments, a light element (e.g., H, He, or Li) is implanted to a uniform target depth within the carrier layer where the fracture plane is desired. Following such a cleaving process, the thickness of the carrier layer remaining in the donor-host substrate assembly may then be polished or etched to complete removal. Alternatively, where the carrier layer is not fractured, the grind, polish and/or etch operation may be employed to remove a greater thickness of the carrier layer.

Next, exposure of an intervening layer is detected. Detection is used to identify a point when the back-side surface of the donor substrate has advanced to nearly the device layer. Any endpoint detection technique known to be suitable for detecting a transition between the materials employed for the carrier layer and the intervening layer may be practiced. In some embodiments, one or more endpoint criteria are based on detecting a change in optical absorbance or emission of the back-side surface of the donor substrate during the polishing or etching performance. In some other embodiments, the endpoint criteria are associated with a change in optical absorbance or emission of byproducts during the polishing or etching of the donor substrate back-side surface. For example, absorbance or emission wavelengths associated with the carrier layer etch byproducts may change as a function of the different compositions of the carrier layer and intervening layer. In other embodiments, the endpoint criteria are associated with a change in mass of species in byproducts of polishing or etching the back-side surface of the donor substrate. For example, the byproducts of processing may be sampled through a quadrupole mass analyzer and a change in the species mass may be correlated to the different compositions of the carrier layer and intervening layer. In another exemplary embodiment, the endpoint criteria is associated with a change in friction between a back-side surface of the donor substrate and a polishing surface in contact with the back-side surface of the donor substrate.

Detection of the intervening layer may be enhanced where the removal process is selective to the carrier layer relative to the intervening layer as non-uniformity in the carrier removal process may be mitigated by an etch rate delta between the carrier layer and intervening layer. Detection may even be skipped if the grind, polish and/or etch operation removes the intervening layer at a rate sufficiently below the rate at which the carrier layer is removed. If an endpoint criteria is not employed, a grind, polish and/or etch operation of a predetermined fixed duration may stop on the intervening layer material if the thickness of the intervening layer is sufficient for the selectivity of the etch. In some examples, the carrier etch rate: intervening layer etch rate is 3:1-10:1, or more.

Upon exposing the intervening layer, at least a portion of the intervening layer may be removed. For example, one or more component layers of the intervening layer may be removed. A thickness of the intervening layer may be removed uniformly by a polish, for example. Alternatively, a thickness of the intervening layer may be removed with a masked or blanket etch process. The process may employ the same polish or etch process as that employed to thin the carrier, or may be a distinct process with distinct process parameters. For example, where the intervening layer provides an etch stop for the carrier removal process, the latter operation may employ a different polish or etch process that favors removal of the intervening layer over removal of the device layer. Where less than a few hundred nanometers of intervening layer thickness is to be removed, the removal process may be relatively slow, optimized for across-wafer uniformity, and more precisely controlled than that employed for removal of the carrier layer. A CMP process employed may, for example employ a slurry that offers very high selectively (e.g., 100:1-300:1, or more) between semiconductor (e.g., silicon) and dielectric material (e.g., SiO) surrounding the device layer and embedded within the intervening layer, for example, as electrical isolation between adjacent device regions.

For embodiments where the device layer is revealed through complete removal of the intervening layer, back-side processing may commence on an exposed back-side of the device layer or specific device regions there in. In some embodiments, the back-side device layer processing includes a further polish or wet/dry etch through a thickness of the device layer disposed between the intervening layer and a device region previously fabricated in the device layer, such as a source or drain region.

In some embodiments where the carrier layer, intervening layer, or device layer back-side is recessed with a wet and/or plasma etch, such an etch may be a patterned etch or a materially selective etch that imparts significant non-planarity or topography into the device layer back-side surface. As described further below, the patterning may be within a device cell (i.e., "intra-cell" patterning) or may be across device cells (i.e., "inter-cell" patterning). In some patterned etch embodiments, at least a partial thickness of the intervening layer is employed as a hard mask for back-side device layer patterning. Hence, a masked etch process may preface a correspondingly masked device layer etch.

The above described processing scheme may result in a donor-host substrate assembly that includes IC devices that have a back-side of an intervening layer, a back-side of the device layer, and/or back-side of one or more semiconductor regions within the device layer, and/or front-side metallization revealed. Additional back-side processing of any of these revealed regions may then be performed during downstream processing.

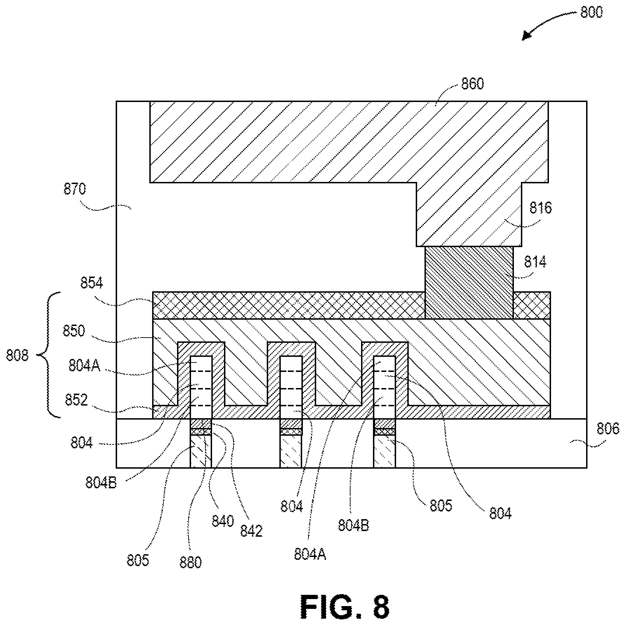

It is to be appreciated that the structures resulting from the above exemplary processing schemes may be used in a same or similar form for subsequent processing operations to complete device fabrication, such as PMOS and/or NMOS device fabrication. As an example of a completed device, Figure 8 illustrates a cross-sectional view of a non-planar integrated circuit structure as taken along a gate line, in accordance with an embodiment of the present disclosure.

Referring to Figure 8, a semiconductor structure or device 800 includes a non-planar active region (e.g., a fin structure including protruding fin portion 804 and sub-fin region 805) within a trench isolation region 806. In an embodiment, instead of a solid fin, the non-planar active region is separated into nanowires (such as nanowires 804A and 804B) above sub-fin region 805, as is represented by the dashed lines. In either case, for ease of description for non-planar integrated circuit structure 800, a non-planar active region 804 is referenced below as a protruding fin portion. In an embodiment, the sub-fin region 805 also includes a relaxed buffer layer 842 and a defect modification layer 840, as is depicted.

A gate line 808 is disposed over the protruding portions 804 of the non-planar active region (including, if applicable, surrounding nanowires 804A and 804B), as well as over a portion of the trench isolation region 806. As shown, gate line 808 includes a gate electrode 850 and a gate dielectric layer 852. In one embodiment, gate line 808 may also include a dielectric cap layer 854. A gate contact 814, and overlying gate contact via 816 are also seen from this perspective, along with an overlying metal interconnect 860, all of which are disposed in inter-layer dielectric stacks or layers 870. Also seen from the perspective of Figure 8, the gate contact 814 is, in one embodiment, disposed over trench isolation region 806, but not over the non-planar active regions. In another embodiment, the gate contact 814 is over the non-planar active regions.

In an embodiment, the semiconductor structure or device 800 is a non-planar device such as, but not limited to, a fin-FET device, a tri-gate device, a nanoribbon device, or a nanowire device. In such an embodiment, a corresponding semiconducting channel region is composed of or is formed in a three-dimensional body. In one such embodiment, the gate electrode stacks of gate lines 808 surround at least a top surface and a pair of sidewalls of the three-dimensional body.

As is also depicted in Figure 8, in an embodiment, an interface 880 exists between a protruding fin portion 804 and sub-fin region 805. The interface 880 can be a transition region between a doped sub-fin region 805 and a lightly or undoped upper fin portion 804. In one such embodiment, each fin is approximately 10 nanometers wide or less, and sub-fin dopants are optionally supplied from an adjacent solid state doping layer at the sub-fin location. In a particular such embodiment, each fin is less than 10 nanometers wide.

Although not depicted in Figure 8, it is to be appreciated that source or drain regions of or adjacent to the protruding fin portions 804 are on either side of the gate line 808, i.e., into and out of the page. In one embodiment, the material of the protruding fin portions 804 in the source or drain locations is removed and replaced with another semiconductor material, e.g., by epitaxial deposition to form epitaxial source or drain structures. The source or drain regions may extend below the height of dielectric layer of trench isolation region 806, i.e., into the sub-fin region 805. In accordance with an embodiment of the present disclosure, the more heavily doped sub-fin regions, i.e., the doped portions of the fins below interface 880, inhibits source to drain leakage through this portion of the bulk semiconductor fins. In an embodiment, the source and drain regions have associated asymmetric source and drain contact structures, as described above in association with Figure 7J.

With reference again to Figure 8, in an embodiment, fins 804/805 (and, possibly nanowires 804A and 804B) are composed of a crystalline silicon germanium layer which may be doped with a charge carrier, such as but not limited to phosphorus, arsenic, boron, gallium or a combination thereof.

In an embodiment, trench isolation region 806, and trench isolation regions (trench isolations structures or trench isolation layers) described throughout, may be composed of a material suitable to ultimately electrically isolate, or contribute to the isolation of, portions of a permanent gate structure from an underlying bulk substrate or isolate active regions formed within an underlying bulk substrate, such as isolating fin active regions. For example, in one embodiment, trench isolation region 806 is composed of a dielectric material such as, but not limited to, silicon dioxide, silicon oxy-nitride, silicon nitride, or carbon-doped silicon nitride.

Gate line 808 may be composed of a gate electrode stack which includes a gate dielectric layer 852 and a gate electrode layer 850. In an embodiment, the gate electrode of the gate electrode stack is composed of a metal gate and the gate dielectric layer is composed of a high-k material. For example, in one embodiment, the gate dielectric layer 852 is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer 852 may include a layer of native oxide formed from the top few layers of the substrate fin 804. In an embodiment, the gate dielectric layer 852 is composed of a top high-k portion and a lower portion composed of an oxide of a semiconductor material. In one embodiment, the gate dielectric layer 852 is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, the gate electrode layer 850 is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode layer 850 is composed of a non-workfunction-setting fill material formed above a metal workfunction-setting layer. The gate electrode layer 850 may consist of a P-type workfunction metal or an N-type workfunction metal, depending on whether the transistor is to be a PMOS or an NMOS transistor. In some implementations, the gate electrode layer 850 may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, tungsten and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

Spacers associated with the gate electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

Gate contact 814 and overlying gate contact via 816 may be composed of a conductive material. In an embodiment, one or more of the contacts or vias are composed of a metal species. The metal species may be a pure metal, such as tungsten, nickel, or cobalt, or may be an alloy such as a metal-metal alloy or a metal-semiconductor alloy (e.g., such as a silicide material).

In an embodiment (although not shown), a contact pattern which is essentially perfectly aligned to an existing gate pattern 808 is formed while eliminating the use of a lithographic step with exceedingly tight registration budget. In an embodiment, the contact pattern is a vertically symmetric contact pattern, or an asymmetric contact pattern such as described in association with Figure 7J. In other embodiments, all contacts are front-side connected and are not asymmetric. In one such embodiment, the self-aligned approach enables the use of intrinsically highly selective wet etching (e.g., versus conventionally implemented dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in conventional approaches. In an embodiment, a trench contact grid is not separately patterned, but is rather formed between poly (gate) lines. For example, in one such embodiment, a trench contact grid is formed subsequent to gate grating patterning but prior to gate grating cuts.

In an embodiment, providing structure 800 involves fabrication of the gate stack structure 808 by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

Referring again to Figure 8, the arrangement of semiconductor structure or device 800 places the gate contact over isolation regions. Such an arrangement may be viewed as inefficient use of layout space. In another embodiment, however, a semiconductor device has contact structures that contact portions of a gate electrode formed over an active region, e.g., over a fin 805, and in a same layer as a trench contact via.

In an embodiment, the structure of Figure 8 can be included in a structure having magnetic vias and backside power delivery, such as described above.

Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a nanowire device, a nanoribbon device, a tri-gate device, an independently accessed double gate device, or a FIN-FET. One or more embodiments may be particularly useful for fabricating semiconductor devices at a sub-10 nanometer (10 nm) technology node.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials, capping layers, or plugs are composed of dielectric materials different from the interlayer dielectric material. In one embodiment, different hardmask, capping or plug materials may be used in different regions so as to provide different growth or etch selectivity to each other and to the underlying dielectric and metal layers. In some embodiments, a hardmask layer, capping or plug layer includes a layer of a nitride of silicon (e.g., silicon nitride) or a layer of an oxide of silicon, or both, or a combination thereof. Other suitable materials may include carbon-based materials. Other hardmask, capping or plug layers known in the arts may be used depending upon the particular implementation. The hardmask, capping or plug layers maybe formed by CVD, PVD, or by other deposition methods.

In an embodiment, as is also used throughout the present description, lithographic operations are performed using 193nm immersion lithography (i193), EUV and/or EBDW lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

In another aspect, one or more embodiments are directed to neighboring semiconductor structures or devices separated by self-aligned gate endcap (SAGE) structures. Particular embodiments may be directed to integration of multiple width (multi-Wsi) nanowires and nanoribbons in a SAGE architecture and separated by a SAGE wall. In an embodiment, nanowires/nanoribbons are integrated with multiple Wsi in a SAGE architecture portion of a front-end process flow. Such a process flow may involve integration of nanowires and nanoribbons of different Wsi to provide robust functionality of next generation transistors with low power and high performance. Associated epitaxial source or drain regions may be embedded (e.g., portions of nanowires removed and then source or drain (S/D) growth is performed).

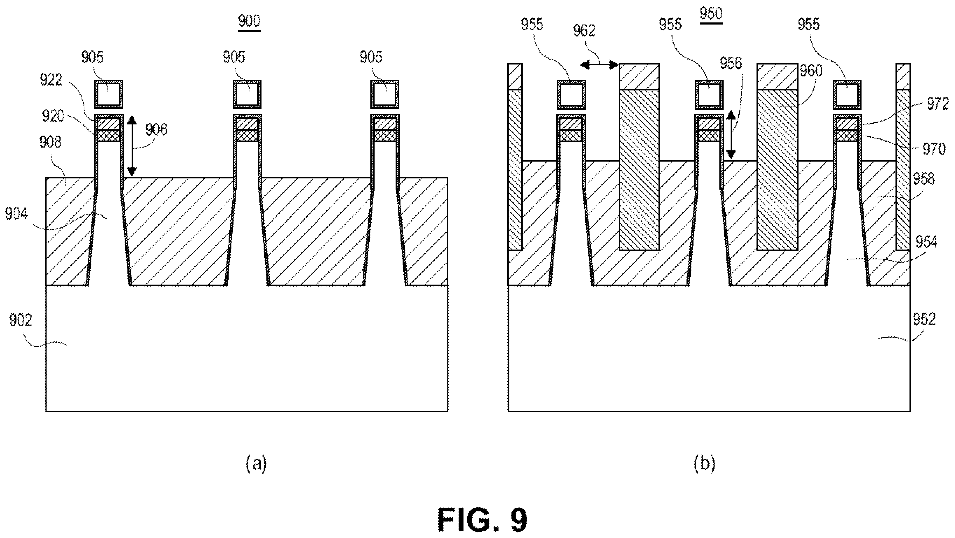

To provide further context, advantages of a self-aligned gate endcap (SAGE) architecture may include the enabling of higher layout density and, in particular, scaling of diffusion to diffusion spacing. To provide illustrative comparison, Figure 9 illustrates cross-sectional views taken through nanowires and fins for a non-endcap architecture (left-hand side (a)) versus a self-aligned gate endcap (SAGE) architecture (right-hand side (b)), in accordance with an embodiment of the present disclosure.

Referring to the left-hand side (a) of Figure 9, an integrated circuit structure 900 includes a substrate 902 having fins 904 protruding there from by an amount 906 above an isolation structure 908 laterally surrounding lower portions of the fins 904. Upper portions of the fins may include a relaxed buffer layer 922 and a defect modification layer 920, as is depicted. Corresponding nanowires 905 are over the fins 904. A gate structure may be formed over the integrated circuit structure 900 to fabricate a device. However, breaks in such a gate structure may be accommodated for by increasing the spacing between fin 904/nanowire 905 pairs.

By contrast, referring to the right-hand side (b) of Figure 9, an integrated circuit structure 950 includes a substrate 952 having fins 954 protruding therefrom by an amount 956 above an isolation structure 958 laterally surrounding lower portions of the fins 954. Upper portions of the fins may include a relaxed buffer layer 972 and a defect modification layer 970, as is depicted. Corresponding nanowires 955 are over the fins 954. Isolating SAGE walls 960 (which may include a hardmask thereon, as depicted) are included within the isolation structure 952 and between adjacent fin 954/nanowire 955 pairs. The distance between an isolating SAGE wall 960 and a nearest fin 954/nanowire 955 pair defines the gate endcap spacing 962. A gate structure may be formed over the integrated circuit structure 900, between insolating SAGE walls to fabricate a device. Breaks in such a gate structure are imposed by the isolating SAGE walls. Since the isolating SAGE walls 960 are self-aligned, restrictions from conventional approaches can be minimized to enable more aggressive diffusion to diffusion spacing. Furthermore, since gate structures include breaks at all locations, individual gate structure portions may be layer connected by local interconnects formed over the isolating SAGE walls 960. In an embodiment, as depicted, the SAGE walls 960 each include a lower dielectric portion and a dielectric cap on the lower dielectric portion. In accordance with an embodiment of the present disclosure, a fabrication process for structures associated with Figure 9 involves use of a process scheme that provides a gate-all-around integrated circuit structure having epitaxial source or drain structures.

In an embodiment, the structure of part (a) of Figure 9 can be including in a structure including magnetic vias and backside power delivery, such as described above. In an embodiment, the structure of part (b) of Figure 9 can be included in a structure having magnetic vias and backside power delivery, such as described above.

A self-aligned gate endcap (SAGE) processing scheme involves the formation of gate/trench contact endcaps self-aligned to fins without requiring an extra length to account for mask mis-registration. Thus, embodiments may be implemented to enable shrinking of transistor layout area. Embodiments described herein may involve the fabrication of gate endcap isolation structures, which may also be referred to as gate walls, isolation gate walls or self-aligned gate endcap (SAGE) walls.

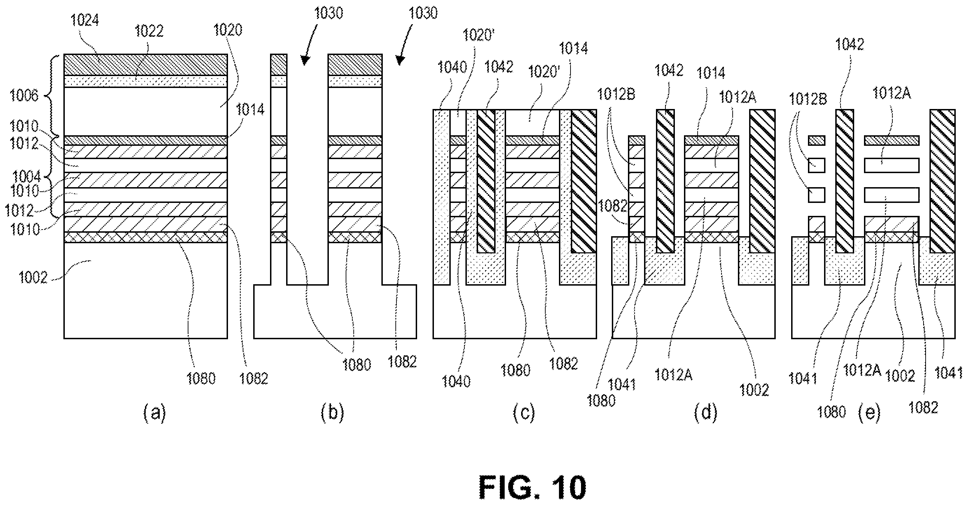

In an exemplary processing scheme for structures having SAGE walls separating neighboring devices, Figure 10 illustrate cross-sectional views representing various operations in a method of fabricating a self-aligned gate endcap (SAGE) structure with gate-all-around devices, in accordance with an embodiment of the present disclosure.

Referring to part (a) of Figure 10, a starting structure includes a nanowire patterning stack 1004 above a substrate 1002. A lithographic patterning stack 1006 is formed above the nanowire patterning stack 1004. The nanowire patterning stack 1004 includes alternating sacrificial layers 1010 and nanowire layers 1012, which may be above a relaxed buffer layer 1082 and a defect modification layer 1080, as is depicted. A protective mask 1014 is between the nanowire patterning stack 1004 and the lithographic patterning stack 1006. In one embodiment, the lithographic patterning stack 1006 is trilayer mask composed of a topographic masking portion 1020, an anti-reflective coating (ARC) layer 1022, and a photoresist layer 1024. In a particular such embodiment, the topographic masking portion 1020 is a carbon hardmask (CHM) layer and the anti-reflective coating layer 1022 is a silicon ARC layer.

Referring to part (b) of Figure 10, the stack of part (a) is lithographically patterned and then etched to provide an etched structure including a patterned substrate 1002 and trenches 1030.

Referring to part (c) of Figure 10, the structure of part (b) has an isolation layer 1040 and a SAGE material 1042 formed in trenches 1030. The structure is then planarized to leave patterned topographic masking layer 1020' as an exposed upper layer.

Referring to part (d) of Figure 10, the isolation layer 1040 is recessed below an upper surface of the patterned substrate 1002, e.g., to define a protruding fin portion and to provide a trench isolation structure 1041 beneath SAGE walls 1042.

Referring to part (e) of Figure 10, the sacrificial layers 1010 are removed at least in the channel region to release nanowires 1012A and 1012B. Subsequent to the formation of the structure of part (e) of Figure 10, a gate stacks may be formed around nanowires 1012B or 1012A, over protruding fins of substrate 1002, and between SAGE walls 1042. In one embodiment, prior to formation of the gate stacks, the remaining portion of protective mask 1014 is removed. In another embodiment, the remaining portion of protective mask 1014 is retained as an insulating fin hat as an artifact of the processing scheme.

Referring again to part (e) of Figure 10, it is to be appreciated that a channel view is depicted, with source or drain regions being locating into and out of the page. In an embodiment, the channel region including nanowires 1012B has a width less than the channel region including nanowires 1012A. Thus, in an embodiment, an integrated circuit structure includes multiple width (multi-Wsi) nanowires. Although structures of 1012B and 1012A may be differentiated as nanowires and nanoribbons, respectively, both such structures are typically referred to herein as nanowires. It is also to be appreciated that reference to or depiction of a fin/nanowire pair throughout may refer to a structure including a fin and one or more overlying nanowires (e.g., two overlying nanowires are shown in Figure 10). In accordance with an embodiment of the present disclosure, a fabrication process for structures associated with Figure 10 involves use of a process scheme that provides a gate-all-around integrated circuit structure having epitaxial source or drain structures.

In an embodiment, the structure of part (e) Figure 10 can be included in a structure having magnetic vias and backside power delivery, such as described above.

In an embodiment, as described throughout, self-aligned gate endcap (SAGE) isolation structures may be composed of a material or materials suitable to ultimately electrically isolate, or contribute to the isolation of, portions of permanent gate structures from one another. Exemplary materials or material combinations include a single material structure such as silicon dioxide, silicon oxy-nitride, silicon nitride, or carbon-doped silicon nitride. Other exemplary materials or material combinations include a multi-layer stack having lower portion silicon dioxide, silicon oxy-nitride, silicon nitride, or carbon-doped silicon nitride and an upper portion higher dielectric constant material such as hafnium oxide.

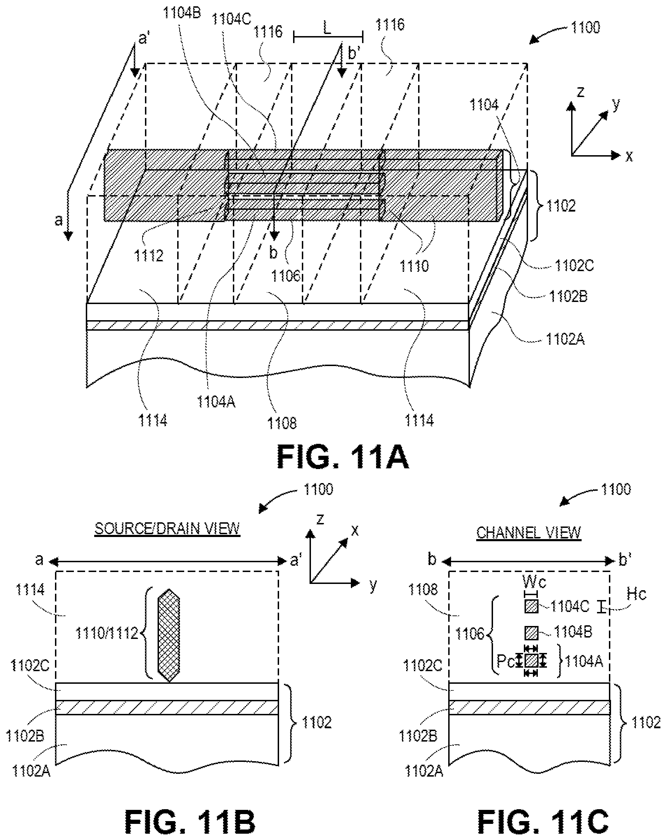

To highlight an exemplary integrated circuit structure having three vertically arranged nanowires, Figure 11A illustrates a three-dimensional cross-sectional view of a nanowire-based integrated circuit structure, in accordance with an embodiment of the present disclosure. Figure 11B illustrates a cross-sectional source or drain view of the nanowire-based integrated circuit structure of Figure 11A, as taken along the a-a' axis. Figure 11C illustrates a cross-sectional channel view of the nanowire-based integrated circuit structure of Figure 11A, as taken along the b-b' axis.

Referring to Figure 11A, an integrated circuit structure 1100 includes one or more vertically stacked nanowires (1104 set) above a substrate 1102. In an embodiment, as depicted, a relaxed buffer layer 1102C, a defect modification layer 1102B, and a lower substrate portion 1102A are included in substrate 1102, as is depicted. An optional fin below the bottommost nanowire and formed from the substrate 1102 is not depicted for the sake of emphasizing the nanowire portion for illustrative purposes. Embodiments herein are targeted at both single wire devices and multiple wire devices. As an example, a three nanowire-based devices having nanowires 1104A, 1104B and 1104C is shown for illustrative purposes. For convenience of description, nanowire 1104A is used as an example where description is focused on one of the nanowires. It is to be appreciated that where attributes of one nanowire are described, embodiments based on a plurality of nanowires may have the same or essentially the same attributes for each of the nanowires.

Each of the nanowires 1104 includes a channel region 1106 in the nanowire. The channel region 1106 has a length (L). Referring to Figure 11C, the channel region also has a perimeter (Pc) orthogonal to the length (L). Referring to both Figures 11A and 11C, a gate electrode stack 1108 surrounds the entire perimeter (Pc) of each of the channel regions 1106. The gate electrode stack 1108 includes a gate electrode along with a gate dielectric layer between the channel region 1106 and the gate electrode (not shown). In an embodiment, the channel region is discrete in that it is completely surrounded by the gate electrode stack 1108 without any intervening material such as underlying substrate material or overlying channel fabrication materials. Accordingly, in embodiments having a plurality of nanowires 1104, the channel regions 1106 of the nanowires are also discrete relative to one another.

Referring to both Figures 11A and 11B, integrated circuit structure 1100 includes a pair of non-discrete source or drain regions 1110/1112. The pair of non-discrete source or drain regions 1110/1112 is on either side of the channel regions 1106 of the plurality of vertically stacked nanowires 1104. Furthermore, the pair of non-discrete source or drain regions 1110/1112 is adjoining for the channel regions 1106 of the plurality of vertically stacked nanowires 1104. In one such embodiment, not depicted, the pair of non-discrete source or drain regions 1110/1112 is directly vertically adjoining for the channel regions 1106 in that epitaxial growth is on and between nanowire portions extending beyond the channel regions 1106, where nanowire ends are shown within the source or drain structures. In another embodiment, as depicted in Figure 11A, the pair of non-discrete source or drain regions 1110/1112 is indirectly vertically adjoining for the channel regions 1106 in that they are formed at the ends of the nanowires and not between the nanowires.

In an embodiment, as depicted, the source or drain regions 1110/1112 are non-discrete in that there are not individual and discrete source or drain regions for each channel region 1106 of a nanowire 1104. Accordingly, in embodiments having a plurality of nanowires 1104, the source or drain regions 1110/1112 of the nanowires are global or unified source or drain regions as opposed to discrete for each nanowire. That is, the non-discrete source or drain regions 1110/1112 are global in the sense that a single unified feature is used as a source or drain region for a plurality (in this case, 3) of nanowires 1104 and, more particularly, for more than one discrete channel region 1106. In one embodiment, from a cross-sectional perspective orthogonal to the length of the discrete channel regions 1106, each of the pair of non-discrete source or drain regions 1110/1112 is approximately rectangular in shape with a bottom tapered portion and a top vertex portion, as depicted in Figure 11B. In other embodiments, however, the source or drain regions 1110/1112 of the nanowires are relatively larger yet discrete non-vertically merged epitaxial structures such as nubs described in association with Figures 7A-7J.

In accordance with an embodiment of the present disclosure, and as depicted in Figures 11A and 11B, integrated circuit structure 1100 further includes a pair of contacts 1114, each contact 1114 on one of the pair of non-discrete source or drain regions 1110/1112. In one such embodiment, in a vertical sense, each contact 1114 completely surrounds the respective non-discrete source or drain region 1110/1112. In another aspect, the entire perimeter of the non-discrete source or drain regions 1110/1112 may not be accessible for contact with contacts 1114, and the contact 1114 thus only partially surrounds the non-discrete source or drain regions 1110/1112, as depicted in Figure 11B. In a contrasting embodiment, not depicted, the entire perimeter of the non-discrete source or drain regions 1110/1112, as taken along the a-a' axis, is surrounded by the contacts 1114.

Referring again to Figure 11A, in an embodiment, integrated circuit structure 1100 further includes a pair of spacers 1116. As is depicted, outer portions of the pair of spacers 1116 may overlap portions of the non-discrete source or drain regions 1110/1112, providing for "embedded" portions of the non-discrete source or drain regions 1110/1112 beneath the pair of spacers 1116. As is also depicted, the embedded portions of the non-discrete source or drain regions 1110/1112 may not extend beneath the entirety of the pair of spacers 1116.

Substrate 1102 may be composed of a material suitable for integrated circuit structure fabrication. In one embodiment, substrate 1102 includes a lower bulk substrate composed of a single crystal of a material which may include, but is not limited to, silicon, germanium, silicon-germanium, germanium-tin, silicon-germanium-tin, or a group III-V compound semiconductor material. An upper insulator layer composed of a material which may include, but is not limited to, silicon dioxide, silicon nitride or silicon oxy-nitride is on the lower bulk substrate. Thus, the structure 1100 may be fabricated from a starting semiconductor-on-insulator substrate. Alternatively, the structure 1100 is formed directly from a bulk substrate and local oxidation is used to form electrically insulative portions in place of the above described upper insulator layer. In another alternative embodiment, the structure 1100 is formed directly from a bulk substrate and doping is used to form electrically isolated active regions, such as nanowires, thereon. In one such embodiment, the first nanowire (i.e., proximate the substrate) is in the form of an omega-FET type structure.

In an embodiment, the nanowires 1104 may be sized as wires or ribbons, as described below, and may have squared-off or rounder corners. In an embodiment, the nanowires 1104 are composed of a material such as, but not limited to, silicon, germanium, or a combination thereof. In one such embodiment, the nanowires are single-crystalline. For example, for a silicon nanowire 1104, a single-crystalline nanowire may be based from a (100) global orientation, e.g., with a <100> plane in the z-direction. As described below, other orientations may also be considered. In an embodiment, the dimensions of the nanowires 1104, from a cross-sectional perspective, are on the nano-scale. For example, in a specific embodiment, the smallest dimension of the nanowires 1104 is less than approximately 20 nanometers. In an embodiment, the nanowires 1104 are composed of a strained material, particularly in the channel regions 1106.

Referring to Figures 11C, in an embodiment, each of the channel regions 1106 has a width (Wc) and a height (Hc), the width (Wc) approximately the same as the height (Hc). That is, in both cases, the channel regions 1106 are square-like or, if corner-rounded, circle-like in cross-section profile. In another aspect, the width and height of the channel region need not be the same, such as the case for nanoribbons as described throughout.

In an embodiment, as described throughout, an integrated circuit structure includes non-planar devices such as, but not limited to, a finFET or a tri-gate device with corresponding one or more overlying nanowire structures. In such an embodiment, a corresponding semiconducting channel region is composed of or is formed in a three-dimensional body with one or more discrete nanowire channel portions overlying the three-dimensional body. In one such embodiment, the gate structures surround at least a top surface and a pair of sidewalls of the three-dimensional body, and further surrounds each of the one or more discrete nanowire channel portions.

In an embodiment, the structure of Figures 11A-11C can be included in a structure having magnetic vias and backside power delivery, such as described above.

In an embodiment, as described throughout, an underlying substrate may be composed of a semiconductor material that can withstand a manufacturing process and in which charge can migrate. In an embodiment, the substrate is a bulk substrate composed of a crystalline silicon, silicon/germanium or germanium layer doped with a charge carrier, such as but not limited to phosphorus, arsenic, boron, gallium or a combination thereof, to form an active region. In one embodiment, the concentration of silicon atoms in a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a group III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a group III-V material and the charge-carrier dopant impurity atoms are ones such as, but not limited to, carbon, silicon, germanium, oxygen, sulfur, selenium or tellurium.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

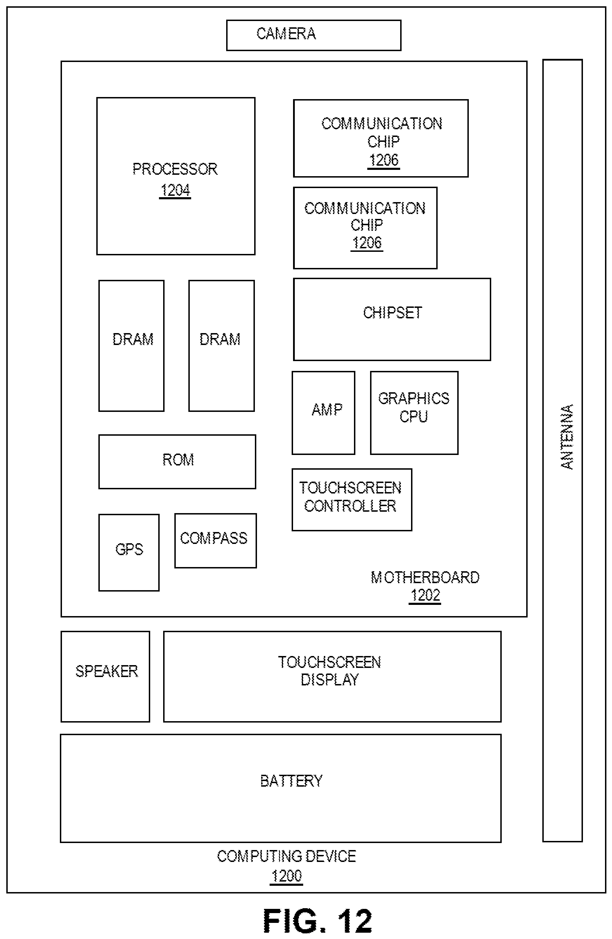

Figure 12 illustrates a computing device 1200 in accordance with one implementation of an embodiment of the present disclosure. The computing device 1200 houses a board 1202. The board 1202 may include a number of components, including but not limited to a processor 1204 and at least one communication chip 1206. The processor 1204 is physically and electrically coupled to the board 1202. In some implementations the at least one communication chip 1206 is also physically and electrically coupled to the board 1202. In further implementations, the communication chip 1206 is part of the processor 1204.

Depending on its applications, computing device 1200 may include other components that may or may not be physically and electrically coupled to the board 1202. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1206 enables wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1206 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1200 may include a plurality of communication chips 1206. For instance, a first communication chip 1206 may be dedicated to shorter range wireless communications such as Wi-Fi and Bluetooth and a second communication chip 1206 may be dedicated to longer range wireless communications such as GPS, EDGE, GPRS, CDMA, WiMAX, LTE, Ev-DO, and others.

The processor 1204 of the computing device 1200 includes an integrated circuit die packaged within the processor 1204. The integrated circuit die of the processor 1204 may include one or more structures, such as gate-all-around integrated circuit structures having magnetic vias and backside power delivery, built in accordance with implementations of embodiments of the present disclosure. The term "processor" may refer to any device or portion of a device that processes electronic data from registers and/or memory to transform that electronic data into other electronic data that may be stored in registers and/or memory.

The communication chip 1206 also includes an integrated circuit die packaged within the communication chip 1206. The integrated circuit die of the communication chip 1206 may include one or more structures, such as gate-all-around integrated circuit structures having magnetic vias and backside power delivery, built in accordance with implementations of embodiments of the present disclosure.

In further implementations, another component housed within the computing device 1200 may contain an integrated circuit die that includes one or structures, such as gate-all-around integrated circuit structures having magnetic vias and backside power delivery, built in accordance with implementations of embodiments of the present disclosure.

In various implementations, the computing device 1200 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 1200 may be any other electronic device that processes data.

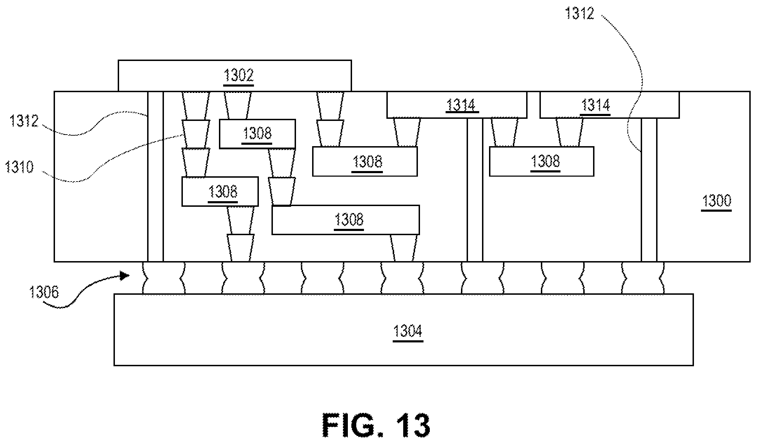

Figure 13 illustrates an interposer 1300 that includes one or more embodiments of the present disclosure. The interposer 1300 is an intervening substrate used to bridge a first substrate 1302 to a second substrate 1304. The first substrate 1302 may be, for instance, an integrated circuit die. The second substrate 1304 may be, for instance, a memory module, a computer motherboard, or another integrated circuit die. Generally, the purpose of an interposer 1300 is to spread a connection to a wider pitch or to reroute a connection to a different connection. For example, an interposer 1300 may couple an integrated circuit die to a ball grid array (BGA) 1306 that can subsequently be coupled to the second substrate 1304. In some embodiments, the first and second substrates 1302/1304 are attached to opposing sides of the interposer 1300. In other embodiments, the first and second substrates 1302/1304 are attached to the same side of the interposer 1300. And in further embodiments, three or more substrates are interconnected by way of the interposer 1300.

The interposer 1300 may be formed of an epoxy resin, a fiberglass-reinforced epoxy resin, a ceramic material, or a polymer material such as polyimide. In further implementations, the interposer 1300 may be formed of alternate rigid or flexible materials that may include the same materials described above for use in a semiconductor substrate, such as silicon, germanium, and other group III-V and group IV materials.

The interposer 1300 may include metal interconnects 1308 and vias 1310, including but not limited to through-silicon vias (TSVs) 1312. The interposer 1300 may further include embedded devices 1314, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1300. In accordance with embodiments of the disclosure, apparatuses or processes disclosed herein may be used in the fabrication of interposer 1300 or in the fabrication of components included in the interposer 1300.

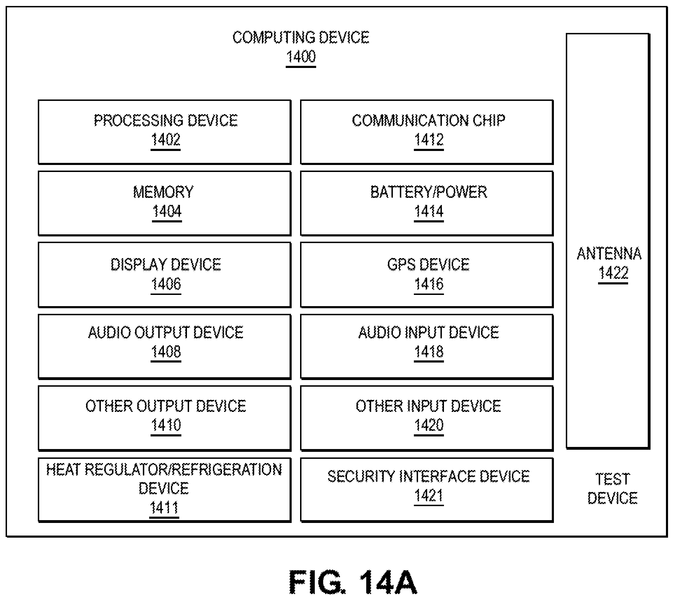

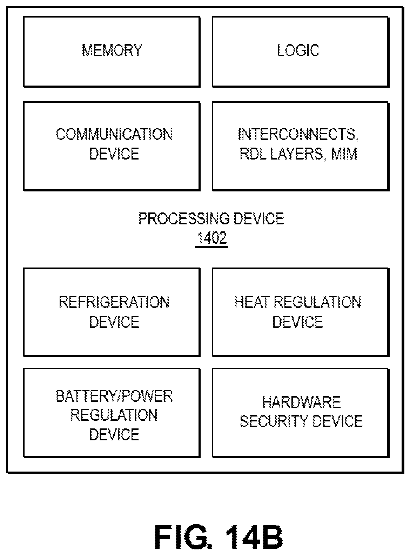

It is to be appreciated that structures described herein may be operated at a low temperature, e.g., in a range of -77 degrees Celsius to 0 degrees Celsius. In one embodiment, a heat regulator/refrigeration device is coupled to a common board having a device with structures such as those described herein coupled thereto, such as described below in association with Figure 14A. In one embodiment, a heat regulator device and/or refrigeration device is included on a processing device having structures such as those described herein, such as described below in association with Figure 14B.

Figure 14A illustrates a computing device 1400 in accordance with one implementation of an embodiment of the present disclosure. The computing device 1400 houses a board. The board may include a number of components, including but not limited to a processing device 1402. The computing device 1400 can also include communication chip 1412. In one embodiment, the processing device 1402 is physically and electrically coupled to the board. In some implementations the communication chip 1412 is also physically and electrically coupled to the board. In further implementations, the communication chip 1412 is part of the processing device 1402.

Depending on its applications, computing device 1400 may include other components that may or may not be physically and electrically coupled to the board. These other components can include, but are not limited to, memory 1404, such as volatile memory (e.g., DRAM), non-volatile memory (e.g., ROM), or flash memory, an antenna 1422, a display device 1406, a battery/power 1414, an audio output device 1408, an audio input device 1418, a global positioning system (GPS) device 1416, an other output device 1410 (such as video output), and other input device 1420 (such as video input), a security interface device 1421, and/or a test device. In one embodiment, a heat regulation/refrigeration device 1411 is included and is coupled to the board, e.g., a device including actively cooled copper channels.

The communication chip 1412 enables wireless communications for the transfer of data to and from the computing device 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1412 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1400 may include a plurality of communication chips 1412. For instance, a first communication chip 1412 may be dedicated to shorter range wireless communications such as Wi-Fi and Bluetooth and a second communication chip 1412 may be dedicated to longer range wireless communications such as GPS, EDGE, GPRS, CDMA, WiMAX, LTE, Ev-DO, and others.

The processing device 1402 of the computing device 1400 can include an integrated circuit die in a package. The processing device 1402 may include one or more structures, such as gate-all-around integrated circuit structures having magnetic vias and backside power delivery, built in accordance with implementations of embodiments of the present disclosure. The term "processing device" may refer to any device or portion of a device that processes electronic data from registers and/or memory to transform that electronic data into other electronic data that may be stored in registers and/or memory.

Figure 14B illustrates a processing device in accordance with one implementation of an embodiment of the present disclosure. Referring to Figure 14B, an exemplary processing device 1402 includes a memory region, a logic region, a communication device region, an interconnects and redistribution layer (RDL) and metal-insulator-metal (MIM) region, a refrigeration device region, a heat regulation device region, a batter/power regulation device region and a hardware security device region. In one embodiment, the refrigeration device region and/or the heat regulation device region is a region including actively cooled copper channels.

Thus, embodiments of the present disclosure include integrated circuit structures having magnetic vias and backside power delivery, and methods of fabricating integrated circuit structures having magnetic vias and backside power delivery.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

## Claims

1. An integrated circuit structure, comprising:
a front-side structure (404) comprising:
a device layer (406) having a plurality of nanowire-based transistors; and
a plurality of metallization layers (408) above the nanowire-based transistors of the device layer (406), wherein one of the metallization layers includes one or more magnetic vias; and
a backside structure (402) below the nanowire-based transistors of the device layer (406), the backside structure (402) including a ground metal line (GM0, GM1),
wherein the one or more magnetic vias are included in an enclosure comprising Cobalt, Zirconium and Tantalum.

2. The integrated circuit structure of claim 1, wherein the one or more magnetic vias is a 2 x 5 array of magnetic vias.

3. The integrated circuit structure of claim 1, wherein the one or more magnetic vias is a 4 x 10 array of magnetic vias.

4. The integrated circuit structure of claim 1, 2 or 3, wherein the one or more magnetic vias are included in a DC-DC convertor comprising the ground metal line.

5. A method of fabricating an integrated circuit structure, the method comprising:
forming a front-side structure, the forming comprising:
forming a device layer having a plurality of nanowire-based transistors; and
forming a plurality of metallization layers above the nanowire-based transistors of the device layer, wherein one of the metallization layers includes one or more magnetic vias; and
forming a backside structure below the nanowire-based transistors of the device layer, the backside structure including a ground metal line,
wherein the one or more magnetic vias are included in an enclosure comprising Cobalt, Zirconium and Tantalum.

6. The method of claim 5, wherein the one or more magnetic vias is a 2 x 5 array of magnetic vias.

7. The method of claim 5, wherein the one or more magnetic vias is a 4 x 10 array of magnetic vias.

8. The method of claim 5, 6 or 7, wherein the one or more magnetic vias are included in a DC-DC convertor comprising the ground metal line.

## Patentansprüche

1. Integrierte Schaltungsstruktur, umfassend:
eine Vorderseitenstruktur (404), die Folgendes umfasst:
eine Vorrichtungsschicht (406) mit mehreren nanodrahtbasierten Transistoren; und
mehrere Metallisierungsschichten (408) über den nanodrahtbasierten Transistoren der Vorrichtungsschicht (406), wobei eine der Metallisierungsschichten einen oder mehrere magnetische Durchkontaktierungen aufweist; und
eine Rückseitenstruktur (402) unterhalb der nanodrahtbasierten Transistoren der Vorrichtungsschicht (406), wobei die Rückseitenstruktur (402) eine Massemetallleitung (GM0, GM1) aufweist,
wobei die eine oder mehreren magnetischen Durchkontaktierungen in einem Gehäuse enthalten sind, das Cobalt, Zirconium und Tantal umfasst.

2. Integrierte Schaltungsstruktur nach Anspruch 1, wobei die eine oder mehreren magnetischen Durchkontaktierungen ein 2x5-Array von magnetischen Durchkontaktierungen sind.

3. Integrierte Schaltungsstruktur nach Anspruch 1, wobei die eine oder mehreren magnetischen Durchkontaktierungen ein 4x10-Array von magnetischen Durchkontaktierungen sind.

4. Integrierte Schaltungsstruktur nach Anspruch 1, 2 oder 3, wobei die eine oder mehreren magnetischen Durchkontaktierungen in einem DC-DC-Wandler enthalten sind, der die Massemetallleitung umfasst.

5. Verfahren zum Fertigen einer integrierten Schaltungsstruktur, das Verfahren umfassend:
Bilden einer Vorderseitenstruktur, wobei das Bilden Folgendes umfasst:
Bilden einer Vorrichtungsschicht mit mehreren nanodrahtbasierten Transistoren; und
Bilden mehrerer Metallisierungsschichten über den nanodrahtbasierten Transistoren der Vorrichtungsschicht, wobei eine der Metallisierungsschichten eine oder mehrere magnetische Durchkontaktierungen aufweist; und
Bilden einer Rückseitenstruktur unterhalb der nanodrahtbasierten Transistoren der Vorrichtungsschicht, wobei die Rückseitenstruktur eine Massemetallleitung aufweist,
wobei die eine oder mehreren magnetischen Durchkontaktierungen in einem Gehäuse enthalten sind, das Cobalt, Zirconium und Tantal umfasst.

6. Verfahren nach Anspruch 5, wobei die eine oder mehreren magnetischen Durchkontaktierungen ein 2x5-Array von magnetischen Durchkontaktierungen sind.

7. Verfahren nach Anspruch 5, wobei die eine oder mehreren magnetischen Durchkontaktierungen ein 4x10-Array von magnetischen Durchkontaktierungen sind.

8. Verfahren nach Anspruch 5, 6 oder 7, wobei die eine oder die mehreren magnetischen Durchkontaktierungen in einem DC-DC-Wandler enthalten sind, der die Massemetallleitung umfasst.

## Revendications

1. Structure de circuit intégré, comprenant :
une structure côté avant (404) comprenant :
une couche de dispositif (406) ayant une pluralité de transistors à base de nanofils ; et
une pluralité de couches de métallisation (408) au-dessus des transistors à base de nanofils de la couche de dispositif (406), dans laquelle une des couches de métallisation inclut un ou plusieurs trous d'interconnexion magnétiques ; et
une structure côté arrière (402) en dessous des transistors à base de nanofils de la couche de dispositif (406), la structure côté arrière (402) incluant une ligne métallique de masse (GM0, GM1),
dans laquelle l'un ou les plusieurs trous d'interconnexion magnétiques sont inclus dans une enceinte comprenant du cobalt, du zirconium, et du tantale.

2. Structure de circuit intégré de la revendication 1, dans laquelle l'un ou les plusieurs trous d'interconnexion magnétiques sont une matrice 2 x 5 de trous d'interconnexion magnétiques.

3. Structure de circuit intégré de la revendication 1, dans laquelle l'un ou les plusieurs trous d'interconnexion magnétiques sont une matrice 4 x 10 de trous d'interconnexion magnétiques.

4. Structure de circuit intégré de la revendication 1, 2, ou 3, dans laquelle l'un ou les plusieurs trous d'interconnexion magnétiques sont inclus dans un convertisseur CC-CC comprenant la ligne métallique de masse.

5. Procédé de fabrication d'une structure de circuit intégré, le procédé comprenant :
la formation d'une structure côté avant, la formation comprenant :
la formation d'une couche de dispositif ayant une pluralité de transistors à base de nanofils ; et
la formation d'une pluralité de couches de métallisation au-dessus des transistors à base de nanofils de la couche de dispositif, dans lequel une des couches de métallisation inclut un ou plusieurs trous d'interconnexion magnétiques ; et
la formation d'une structure côté arrière en dessous des transistors à base de nanofils de la couche de dispositif, la structure côté arrière incluant une ligne métallique de masse,
dans laquelle l'un ou les plusieurs trous d'interconnexion magnétiques sont inclus dans une enceinte comprenant du cobalt, du zirconium, et du tantale.

6. Procédé de la revendication 5, dans lequel l'un ou les plusieurs trous d'interconnexion magnétiques sont une matrice 2 x 5 de trous d'interconnexion magnétiques.

7. Procédé de la revendication 5, dans lequel l'un ou les plusieurs trous d'interconnexion magnétiques sont une matrice 4 x 10 de trous d'interconnexion magnétiques.

8. Procédé de la revendication 5, 6, ou 7, dans lequel l'un ou les plusieurs trous d'interconnexion magnétiques sont inclus dans un convertisseur CC-CC comprenant la ligne métallique de masse.
